# EUROPEAN PATENT APPLICATION

(11) **EP 2 858 103 A1**
(43) Date of publication of application: **08.04.2015**
(21) Application number: 14178198.9
(22) Date of filing: 23.07.2014
(51) Int. Cl.: H01L 21/67, C23C 16/48

(54) **Chamber apparatus and heating method**

(30) Priority: 30.08.2013 JP 2013180600
(71) Applicant: TOKYO OHKA KOGYO CO., LTD., Kawasaki-shi, Kanagawa-ken (JP)
(72) Inventor: Sahoda, Tsutomu, Kanagawa-Ken (JP); Masu, Yoshiaki, Kanagawa-Ken (JP); Miyamoto, Hidenori, Kanagawa-Ken (JP); Kikuchi, Yubun, Kanagawa-Ken (JP)
(74) Representative: Cabinet Plasseraud

(57) **Abstract**

Provided is a chamber apparatus which includes a chamber, in a part of which an internal space capable of accommodating a substrate therein is formed, a heating portion which heats the substrate disposed in the internal space, and a temperature adjustment portion which adjusts the temperature of a part of the chamber, which is in contact with the internal space.

## Description

### CROSS-REFERENCE TO RELATED APPLICATIONS

Priority is claimed on Japanese Patent Application No. 2013-180600, filed August 30, 2013, the content of which is incorporated herein by reference.

### BACKGROUND OF THE INVENTION

### FIELD OF THE INVENTION

The present invention relates to a chamber apparatus and a heating method.

### BACKGROUND ART

A CIGS type solar cell or a CZTS type solar cell which is constituted by a semiconductor material containing metals, such as Cu, Ge, Sn, Pb, Sb, Bi, Ga, In, Ti, Zn, or a combination of these, and a chalcogen element, such as S, Se, Te, or a combination of these, has attracted attention as a solar cell having high conversion efficiency (for example, see Japanese Unexamined Patent Application, First Publication No. H11-340482, Japanese Unexamined Patent Application, First Publication No. 2005-51224, and Japanese Translation of PCT International Publication No. 2009-537997).

The CZTS type solar cell, for example, has a configuration in which a film constituted by, for example, four kinds of semiconductor materials, such as Cu, Zn, Sn and Se, is used as a light absorbing layer (a photoelectric conversion layer). A configuration in which a back electrode constituted by, for example, molybdenum is provided on a substrate constituted by, for example, glass and the light absorbing layer described above is disposed on the back electrode, has been known as the configuration of such a solar cell.

The CZTS type solar cell can achieve a reduction in thickness of a light absorbing layer, compared to a solar cell of the related art, and thus installation on a curved surface and transferring thereof can be easily performed. Therefore, application to a wide range of fields is expected as a flexible solar cell having high performance. Hitherto, a method in which a light absorbing layer is formed by a vapor deposition method, a sputtering method, or the like has been known as a method for forming a light absorbing layer (for example, see Japanese Unexamined Patent Application, First Publication No. 2005-51224, Japanese Translation of PCT International Publication No. 2009-537997, Japanese Unexamined Patent Application, First Publication No. H01-231313, and Japanese Unexamined Patent Application, First Publication No. H11-273783).

However, an inventor of this invention proposes, as a method for forming a light absorbing layer, a method in which a coating film is formed in such a manner that the above-described semiconductor material in a liquid-body state is applied onto a substrate and the substrate is subjected to heating. When the coating film is subjected to heating, heating is performed in a state where the substrate is accommodated in a chamber. After the substrate is subjected to heating, the substrate is carried out from the chamber. Then, the chamber is subjected to cooling. This process has a problem as follows.

When the substrate is subjected to heating, a part of a substance contained in the liquid body is vaporized and floats in the chamber. In some cases, even after the heating is finished and the substrate is carried out, this vaporized substance still floats in the chamber. When the chamber in a state described above is subjected to cooling, a part of the vaporized substance is solidified and adheres to an inner wall of the chamber. This results in contamination.

The invention is made in consideration of the circumstance described above and an object of the invention is to provide a chamber apparatus and a heating method in which a substrate can be accommodated in a clean environment.

### SUMMARY OF THE INVENTION

According to an aspect of the invention, there is provided a chamber apparatus which includes a chamber, in a part of which an internal space capable of accommodating a substrate therein is formed, a heating portion which heats the substrate disposed in the internal space, and a temperature adjustment portion which adjusts the temperature of a part of the chamber, which is in contact with the internal space.

In this case, the temperature of a part of the chamber, which is in contact with the internal space, is adjusted by the temperature adjustment portion, and thus it is possible to prevent the vaporized substance from adhering to the part in contact with the internal space. As a result, the substrate can be accommodated in a clean environment.

In the chamber apparatus, it is preferable that the chamber have a second temperature adjustment portion which can adjust the temperature of the substrate disposed in the internal space.

In this case, the temperature of the substrate is adjusted using the second temperature adjustment portion, and thus the vaporized substance existing in the internal space can be promoted so as to be solidified on the substrate. As a result, it is possible to reduce the total amount of the vaporized substance existing in the internal space, and thus a clean environment of the internal space can be maintained.

In the chamber apparatus, it is preferable that the chamber have a substrate holding portion which holds the substrate disposed in the internal space. In addition, it is preferable that the second temperature adjustment portion be provided in the substrate holding portion.

In this case, the temperature of the substrate can be adjusted through the substrate holding portion. As a result, it is possible to effectively perform the temperature adjustment.

In the chamber apparatus, it is preferable that the second temperature adjustment portion have a flow path through which a temperature adjusting medium capable of heating or cooling the substrate holding portion flows.

In this case, the substrate holding portion is subjected to heating or cooling, using the temperature adjusting medium. As a result, it is possible to effectively perform the temperature adjustment.

In the chamber apparatus, it is preferable that the heating portion be provided in the substrate holding portion.

In this case, it is possible to effectively perform the temperature adjustment or cooling of the substrate holding portion which is subjected to heating by the heating portion.

In the chamber apparatus, it is preferable that the chamber have a wall portion which surrounds the substrate disposed in the internal space. In addition, it is preferable that the temperature adjustment portion be provided in the wall portion.

In this case, the temperature of the wall portion can be adjusted, and thus it is possible to prevent the vaporized substance existing in the internal space from adhering to the wall portion.

In the chamber apparatus, it is preferable that the temperature adjustment portion be provided in an inner portion of the wall portion.

In this case, the temperature of the wall portion can be adjusted from the inner side of the wall portion. As a result, it is possible to effectively perform the temperature adjustment and a part of the wall portion, which is in contact with the internal space, can be formed in a flat shape.

In the chamber apparatus, it is preferable that the chamber have an opening portion which allows the internal space to communicate with the outside, and a first gate portion which can block the opening portion. In addition, it is preferable that the temperature adjustment portion be provided in the first gate portion.

In this case, it is possible to adjust the temperature of the first gate, and thus it is possible to prevent the vaporized substance existing in the internal space from adhering to the first gate.

In the chamber apparatus, it is preferable that the chamber have a second gate portion which can block the opening portion. In addition, it is preferable that the temperature adjustment portion be provided in the second gate portion.

In this case, when the opening portion is opened/closed by the first gate and the second gate, it is also possible to adjust the temperature of the second gate. As a result, it is possible to prevent the vaporized substance existing in the internal space from adhering to the second gate, and thus it is possible to ensure the reliability of an opening/closing operation of the second gate.

In the chamber apparatus, it is preferable that the chamber have a transfer portion which can move in a predetermined direction in the internal space and which performs transferring of the substrate between the transfer portion and the substrate holding portion and a second wall portion which surrounds a movement path of the transfer portion. In addition, it is preferable that the temperature adjustment portion be provided in the second wall portion.

In this case, it is also possible to adjust the temperature of the second wall portion, and thus it is possible to ensure cleanliness of the movement path of the transfer portion.

According to another aspect of the invention, there is provided a heating method which includes an accommodating step of a substrate in a chamber, in a part of which an internal space capable of accommodating the substrate therein is formed, a heating step for heating the substrate disposed in the internal space, and a temperature adjusting step for adjusting the temperature of a part of the chamber, which is in contact with the internal space.

In this case, the temperature of a part of the chamber, which is in contact with the internal space, is adjusted, and thus it is possible to prevent the substance vaporized in the heating step from adhering to the part in contact with the internal space. As a result, it is possible to heat the substrate in a state where the substrate is accommodated in a clean environment.

In the heating method, it is preferable that the temperature adjusting step include a second temperature adjusting step for adjusting the temperature of the substrate disposed in the internal space.

In this case, the temperature of the substrate is adjusted, and thus the vaporized substance existing in the internal space can be promoted so as to be solidified on the substrate. As a result, it is possible to reduce the total amount of the vaporized substance existing in the internal space, and thus a clean environment of the internal space can be maintained.

In the heating method, it is preferable that the accommodating step include holding the substrate in a substrate holding portion disposed in the internal space. In addition, it is preferable that the second temperature adjusting step include adjusting the substrate holding portion.

In this case, the temperature of the substrate can be adjusted through the substrate holding portion, and thus it is possible to effectively perform the temperature adjustment.

In the heating method, it is preferable that the second temperature adjusting step include flowing a temperature adjusting medium capable of cooling the substrate holding portion through a flow path provided in the substrate holding portion.

In this case, the temperature adjusting medium capable of cooling the substrate holding portion flows through the flow path provided in the substrate holding portion, and thus it is possible to effectively perform the cooling operation.

In the heating method, it is preferable that the heating step include heating the substrate holding portion.

In this case, during the second temperature adjusting step, the temperature adjustment or cooling of the heated substrate holding portion can be effectively performed.

In the heating method, it is preferable that the chamber have a wall portion which surrounds the substrate disposed in the internal space. In addition, it is preferable that the temperature adjusting step include adjusting the temperature of the wall portion.

In this case, the temperature of the wall portion is adjusted, and thus it is possible to prevent the vaporized substance existing in the internal space from adhering to the wall portion.

In the heating method, it is preferable that the temperature adjusting step include adjusting the temperature of the wall portion from an inner side thereof.

In this case, the temperature of the wall portion is adjusted from the inner side of the wall portion, and thus it is possible to effectively perform the temperature adjustment.

In the heating method, it is preferable that the chamber have an opening portion which allows the internal space to communicate with the outside, and a first gate portion which can block the opening portion. In addition, it is preferable that the temperature adjusting step include adjusting the temperature of the first gate portion.

In this case, the temperature of the first gate portion is adjusted, and thus it is possible to prevent the vaporized substance existing in the internal space from adhering to the first gate portion.

In the heating method, it is preferable that the chamber have a second gate portion which can block the opening portion. In addition, it is preferable that the temperature adjusting step include adjusting the temperature of the second gate portion.

In this case, the temperatures of both the first gate and the second gate are adjusted, and thus it is possible to prevent the vaporized substance existing in the internal space from adhering not only to the first gate but also to the second gate.

In the heating method, it is preferable that the chamber have a transfer portion which can move in a predetermined direction in the internal space and which performs transferring of the substrate between the transfer portion and the substrate holding portion, and a second wall portion which surrounds a movement path of the transfer portion. In addition, it is preferable that the temperature adjusting step include adjusting the temperature of the second wall portion.

In this case, the temperature of the second wall portion is adjusted, and thus it is possible to ensure cleanliness of the movement path of the transfer portion.

According to the invention, the substrate can be accommodated under a clean environment.

### BRIEF DESCRIPTION OF THE DRAWINGS

Fig. 1 is a view illustrating an entire configuration of a coating applicator according to an embodiment of the invention.
Fig. 2 is a view illustrating an entire configuration of the coating applicator according to the embodiment.
Figs. 3A and 3B are views illustrating a configuration of a nozzle portion according to the embodiment.
Fig. 4 is a view illustrating a configuration of a part of a coating application portion according to the embodiment.
Fig. 5 is a view illustrating a configuration of a vacuum drying portion according to the embodiment.
Fig. 6 is a view illustrating a configuration of a part of a baking portion according to the embodiment.
Fig. 7 is a view illustrating a configuration of a part of the baking portion according to the embodiment.
Fig. 8 is a view illustrating a process of a coating treatment of the coating applicator according to the embodiment.
Fig. 9 is a view illustrating the process of the coating treatment of the coating applicator according to the embodiment.
Fig. 10 is a view illustrating the process of the coating treatment of the coating applicator according to the embodiment.
Fig. 11 is a view illustrating the process of the coating treatment of the coating applicator according to the embodiment.
Fig. 12 is a view illustrating the process of the coating treatment of the coating applicator according to the embodiment.
Fig. 13 is a view illustrating a process of a vacuum drying treatment of the coating applicator according to the embodiment.
Fig. 14 is a view illustrating the process of the vacuum drying treatment of the coating applicator according to the embodiment.
Fig. 15 is a view illustrating the process of the vacuum drying treatment of the coating applicator according to the embodiment.
Fig. 16 is a view illustrating the process of the vacuum drying treatment of the coating applicator according to the embodiment.
Fig. 17 is a view illustrating a process of a baking treatment of the coating applicator according to the embodiment.
Fig. 18 is a view illustrating the process of the baking treatment of the coating applicator according to the embodiment.
Fig. 19 is a view illustrating the process of the baking treatment of the coating applicator according to the embodiment.
Fig. 20 is a view illustrating the process of the baking treatment of the coating applicator according to the embodiment.
Fig. 21 is a view illustrating the process of the baking treatment of the coating applicator according to the embodiment.
Fig. 22 is a view illustrating the process of the baking treatment of the coating applicator according to the embodiment.
Fig. 23 is a view illustrating the process of the baking treatment of the coating applicator according to the embodiment.
Fig. 24 is a view illustrating a configuration of a coating applicator according to a modification example.
Fig. 25 is a view illustrating a configuration of a coating applicator according to a modification example.
Fig. 26 is a view illustrating a configuration of a coating applicator according to a modification example.
Fig. 27 is a view illustrating a configuration of a coating applicator according to a modification example.
Fig. 28 is a view illustrating a configuration of a coating applicator according to a modification example.

### DETAILED DESCRIPTION OF THE INVENTION

Hereinafter, an embodiment of the invention will be described with reference to the accompanying drawings.

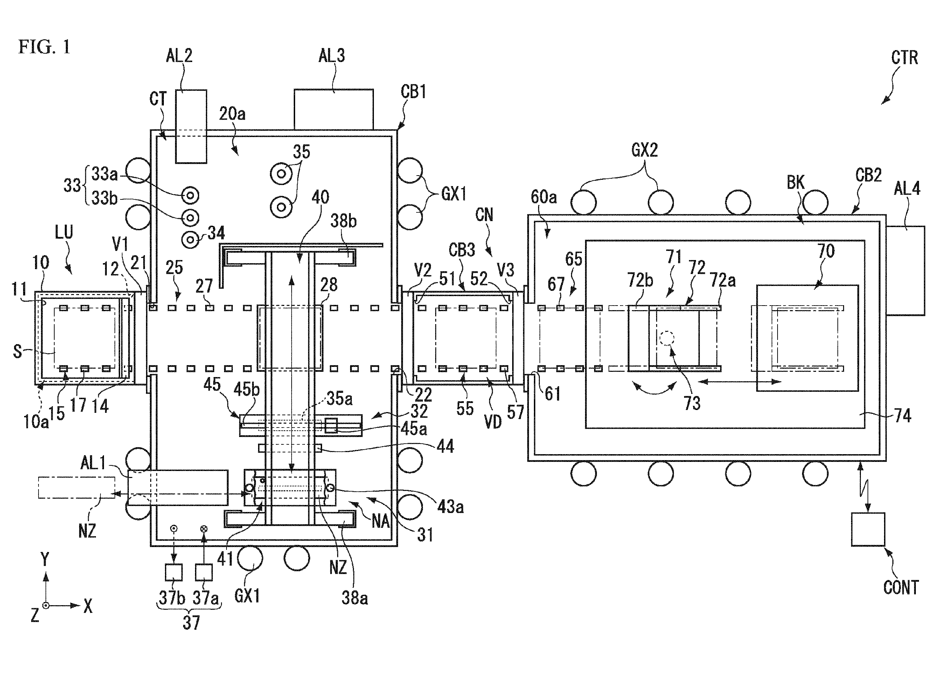

Fig. 1 is a schematic view illustrating a configuration of a coating applicator CTR according to the embodiment.

The coating applicator CTR is a device which applies a liquid body to a substrate S, as illustrated in Fig. 1. The coating applicator CTR has a substrate supplying/collecting portion LU, a first chamber CB1, a second chamber CB2, a connection portion CN, and a control portion CONT. The first chamber CB1 has a coating application portion CT. The second chamber CB2 has a baking portion BK. The connection portion CN has a vacuum drying portion VD.

The coating applicator CTR is used in a state where, for example, the coating applicator CTR is mounted on a floor surface FL of a factory or the like. The coating applicator CTR may be accommodated in one room. Alternatively, the coating applicator CTR may be divided into several portions and accommodated in a plurality of rooms. In the coating applicator CTR, the substrate supplying/collecting portion LU, the coating application portion CT, the vacuum drying portion VD, and the baking portion BK are arranged in one direction in this order.

Although a configuration in which the substrate supplying/collecting portion LU, the coating application portion CT, the vacuum drying portion VD, and the baking portion BK are arranged, in the coating applicator CTR, in one direction in this order is exemplified, the configuration of a apparatus is not limited thereto. The substrate supplying/collecting portion LU may be divided into a substrate supplying portion (not illustrated) and a substrate collecting portion (not illustrated), for example. The vacuum drying portion VD may not be provided. Needless to say, the portions constituting the coating applicator CTR may not be arranged in one direction. The components described above may be arranged to overlap in the vertical direction, with a robot (not illustrated) located in a central position. Alternatively, the components described above may be arranged in a right-left direction.

For simplicity of illustration, when the configuration of a substrate treatment device according to the embodiment is described, directions in the drawings will be described, using an XYZ coordinate system, in the illustration of the drawings described below. In the XYZ coordinate system, a plane parallel to a floor surface is set to an XY plane. In the XY plane, a direction in which the respective components (the substrate supplying/collecting portion LU, the coating application portion CT, the vacuum drying portion VD, and the baking portion BK) of the coating applicator CTR are aligned is set to an X direction and a direction which is perpendicular, on the XY plane, to the X direction is set to a Y direction. A direction perpendicular to the XY plane is set to a Z direction. In the following description, in the X direction, the Y direction, and the Z direction, arrow directions in the drawings are +directions and directions opposite to the arrow directions are -directions.

In the embodiment, a plate-shaped member formed of, for example, glass or resin is used as the substrate S. Furthermore, in the embodiment, a molybdenum portion is formed, as a back electrode, on the substrate S in a sputtering manner. Needless to say, a conductive material other than molybdenum may be used as a back electrode. In the following description, a substrate of which the size is 330 mm x 330 mm when viewed in the Z direction is exemplified as the substrate S. However, the size of the substrate S is not limited to 330 mm x 330 mm described above. A substrate of which the size is 125 mm x 125 mm, for example, may be used as the substrate S and a substrate of which the size is 1 m x 1 m may be used as the substrate S. Needless to say, a substrate of which the size is larger or smaller than the sizes described above can be appropriately used.

In the embodiment, a liquid composition in which metal, such as a group of copper (Cu), indium (In), gallium (Ga), selenium (Se) or a group of copper (Cu), zinc (Zn), tin (Sn), and selenium (Se), is contained in a specified solvent is used as the liquid body applied to the substrate S. This liquid composition contains a metal material which constitutes a light absorbing layer (a photoelectric conversion layer) of a CIGS or CZTS type solar cell.

In the embodiment, this liquid composition contains substance for ensuring a grain size of the light absorbing layer of the CIGS or CZTS type solar cell. Needless to say, a liquid body in which metal other than the materials described above, for example, metal nano particles, is dispersed may be used as the liquid body.

### Substrate Supplying/Collecting Portion

The substrate supplying/collecting portion LU supplies, to the coating application portion CT, the substrate S not subjected to a treatment and collects, from the coating application portion CT, the substrate S having been subjected to a treatment. The substrate supplying/collecting portion LU has a chamber 10. The chamber 10 is formed in a rectangular box shape. An accommodation chamber 10a in which the substrate S can be accommodated is formed in the chamber 10. The chamber 10 has a first opening portion 11, a second opening portion 12, and a lid portion 14. The first opening portion 11 and the second opening portion 12 allow the accommodation chamber 10a to communicate with the outside of the chamber 10.

The first opening portion 11 is formed on a +Z side surface of the chamber 10. The size of the first opening portion 11 is larger than the size of the substrate S, when viewed in the Z direction. The substrate S taken out to the external portion of the chamber 10 or the substrate S to be accommodated in the accommodation chamber 10a is put in/out to/from the substrate supplying/collecting portion LU through the first opening portion 11.

The second opening portion 12 is formed on a +X side surface of the chamber 10. The size of the second opening portion 12 is larger than the size of the substrate S, when viewed in the X direction. The substrate S supplied to the coating application portion CT or the substrate S returned from the coating application portion CT is put in/out to/from the substrate supplying/collecting portion LU through the second opening portion 12.

The lid portion 14 causes the first opening portion 11 to be opened or closed. The lid portion 14 is formed in a rectangular plate shape. The lid portion 14 is installed in the +X side vicinity of the first opening portion 11, via a hinge portion (not illustrated). Thus, the lid portion 14 pivots on a Y axis, with the +X side vicinity of the first opening portion 11 as a center. The first opening portion 11 can be opened or closed in such a manner that the lid portion 14 pivots on the Y axis.

A substrate transport portion 15 is provided in the accommodation chamber 10a. The substrate transport portion 15 has a plurality of rollers 17. The rollers 17 are arranged in the Y direction to form a pair and a plurality of the pairs of the rollers 17 are aligned in the X direction.

Each roller 17 is provided rotatably about the Y axis, with a Y axis direction as a central axis direction. The diameters of the plurality of the rollers 17 are the same and +Z side end portions of the plurality of the rollers 17 are arranged on the same plane parallel to the XY plane. Thus, the plurality of the rollers 17 can support the substrate S such that the posture of the substrate S is parallel to the XY plane.

Rotation of each roller 17 is controlled by, for example, a roller rotation control portion (not illustrated). In a state where the plurality of the rollers 17 support the substrate S, the substrate transport portion 15 causes each roller 17 to rotate about the Y axis, in the clockwise direction or in the counter-clockwise direction. Therefore, the substrate S is transported in the X direction (the +X direction or the -X direction). A floating transport portion (not illustrated) which transports a substrate in a floating manner may be used as the substrate transport portion 15.

### First Chamber

The first chamber CB1 is disposed on a base stage BC which is mounted on the floor surface FL. The first chamber CB1 is formed in a rectangular box shape. A treatment chamber 20a is formed in the first chamber CB1. The coating application portion CT is provided in the treatment chamber 20a. The coating application portion CT performs a liquid-body coating treatment on the substrate S.

The first chamber CB1 has a first opening portion 21 and a second opening portion 22. The first opening portion 21 and the second opening portion 22 allow the treatment chamber 20a to communicate with the outside of the first chamber CB1. The first opening portion 21 is formed on a -X side surface of the first chamber CB1. The second opening portion 22 is formed on a +X side surface of the first chamber CB1. The first opening portion 21 and the second opening portion 22 are formed in a size allowing the substrate S to pass therethrough. The substrate S is put in/out to/from the first chamber CB1 through the first opening portion 21 and the second opening portion 22.

The coating application portion CT has a discharge portion 31, a maintenance portion 32, a liquid-body supply portion 33, a cleaning solution supply portion 34, a waste liquid storage portion 35, a gas supply/discharge portion 37, and substrate transport portion 25.

The discharge portion 31 has a nozzle portion NZ, a treatment stage 28, and a nozzle driving portion NA.

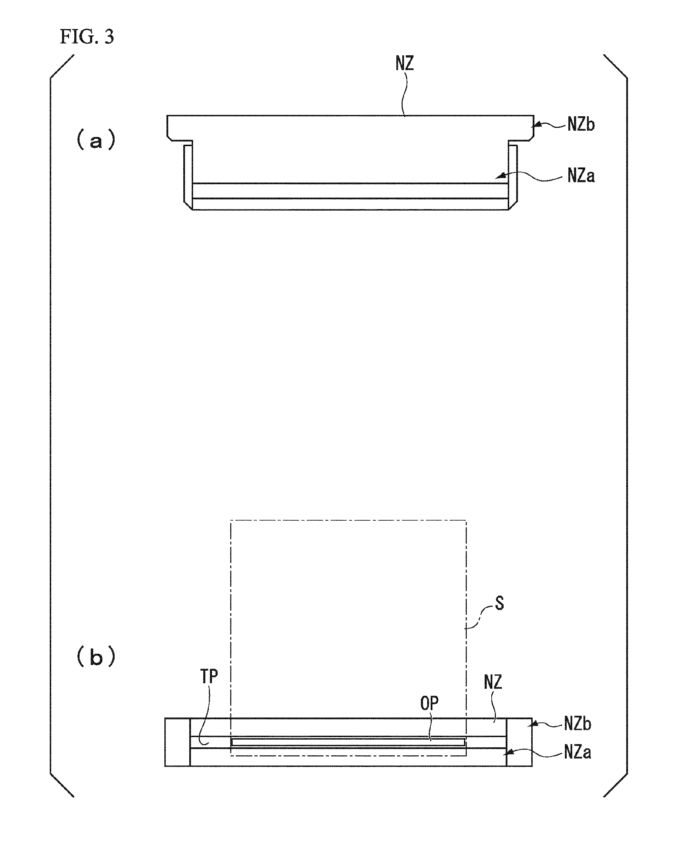

Fig. 3A is a view illustrating a configuration of the nozzle portion NZ.

The nozzle portion NZ is formed in an elongated shape, as illustrated in Fig. 3A, and the nozzle portion NZ is disposed in a state where a longitudinal direction thereof is set to be parallel to the X direction. The nozzle portion NZ has a main body portion NZa and protrusion portions NZb. The main body portion NZa is a case in which a liquid body can be accommodated. The main body portion NZa is constituted by a material containing, for example, titanium or titanium alloy. The protrusion portions NZb are formed to protrude from the main body portion NZa to the +X side and -X side. The protrusion portions NZb are held by a part of the nozzle driving portion NA.

Fig. 3B illustrates the configuration of the nozzle portion NZ, when viewed from the -Z side.

In the nozzle portion NZ, a discharge port OP is provided on a -Z side end portion (a tip TP) of the main body portion NZa, as illustrated in Fig. 3B. The discharge port OP is an opening portion through which the liquid body is discharged. The discharge port OP is formed in a slit shape of which the longitudinal direction is the X direction. The length in the discharge port OP in, for example, the longitudinal direction is approximately the same length as that of the substrate S in the X direction.

The nozzle portion NZ discharges the liquid body in which four kinds of metals, for example, Cu, In, Ga, and Se, are mixed in a predetermined composition ratio. The nozzle portion NZ is connected to the liquid-body supply portion 33 through connection piping (not illustrated) or the like. The nozzle portion NZ has a holding portion in which the liquid body is held. In addition, a temperature adjustment portion which adjusts the temperature of the liquid body held in the holding portion may be provided.

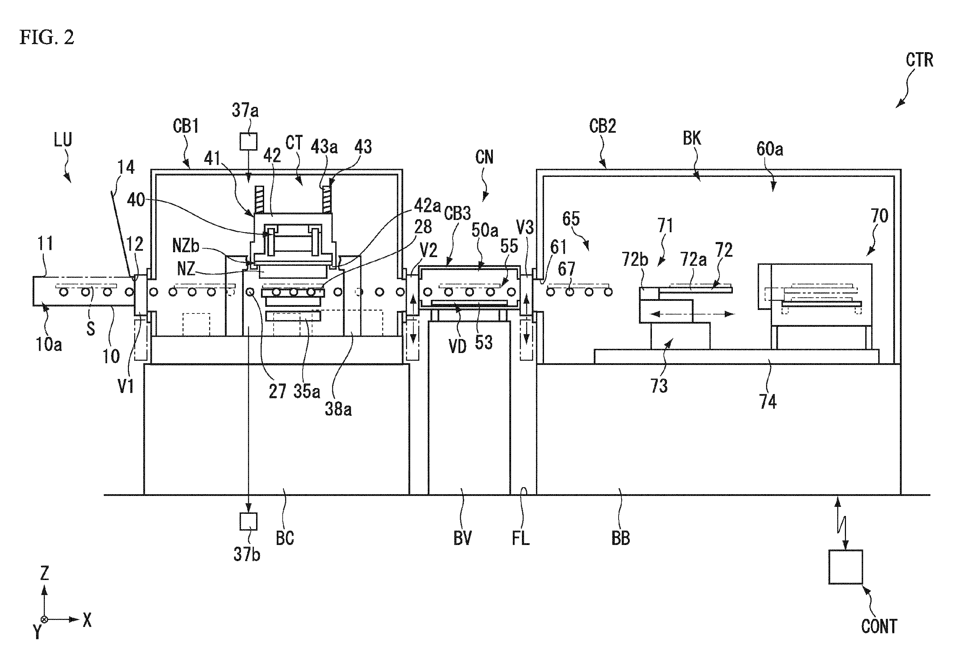

Returning to Figs. 1 and 2, the substrate S which is a target of the coating treatment is mounted on the treatment stage 28. A +Z side surface of the treatment stage 28 is a substrate mounting surface on which the substrate S is mounted. The substrate mounting surface is formed to be parallel to the XY plane. The treatment stage 28 is constituted by, for example, stainless steel.

The nozzle driving portion NA causes the nozzle portion NZ to move in the X direction. The nozzle driving portion NA has a stator 40 and a movable element 41 which constitute a linear motor mechanism. A driving mechanism other than the linear motor mechanism, for example, a ball-screw mechanism, may be used in the configuration of the nozzle driving portion NA. The stator 40 extends in the Y direction. The stator 40 is supported by a support frame 38. The support frame 38 has a first frame 38a and a second frame 38b. The first frame 38a is disposed on the -Y side end portion of the treatment chamber 20a. In the treatment chamber 20a, the second frame 38b is disposed in a position where the treatment stage 28 is interposed between the first frame 38a and the second frame 38b.

The movable element 41 is movable in an extending direction (the Y direction) of the stator 40. The movable element 41 has a nozzle support member 42 and a lifting portion 43. The nozzle support member 42 is formed in a gate shape and has a holding portion 42a which holds the protrusion portion NZb of the nozzle portion NZ. The nozzle support member 42 and the lifting portion 43 integrally move, along the stator 40 and in the Y direction, between the first frame 38a and the second frame 38b. Thus, the nozzle portion NZ held by the nozzle support member 42 moves over the treatment stage 28 in the Y direction. The nozzle support member 42 moves, in the Z direction, along a lifting guide 43a of the lifting portion 43. The movable element 41 has a driving source (not illustrated) which causes the nozzle support member 42 to move in the Y direction and the Z direction.

The maintenance portion 32 is a portion in which maintenance of the nozzle portion NZ is performed. The maintenance portion 32 has a nozzle waiting portion 44 and a nozzle tip maintenance portion 45.

The nozzle waiting portion 44 has a dip portion (not illustrated) and a discharge portion (not illustrated). The dip portion is a portion into which the tip TP of the nozzle portion NZ is dipped so as to prevent the tip TP from being dried. The discharge portion is a portion which discharges the liquid body held in the nozzle portion NZ, in a case where the nozzle portion NZ is exchanged or the liquid body to be supplied to the nozzle portion NZ is exchanged.

The nozzle tip maintenance portion 45 is a portion in which condition of a nozzle tip end is managed in such a manner that the tip TP of the nozzle portion NZ or the vicinity of the tip TP is cleaned or the liquid body is preliminary discharged through the discharge port OP of the nozzle portion NZ. The nozzle tip maintenance portion 45 has a wiping portion 45a which wipes the tip TP of the nozzle portion NZ and a guide rail 45b which guides the wiping portion 45a. A waste liquid accommodating portion 35a in which the liquid body discharged through the nozzle portion NZ, the cleaning solution used for cleaning the nozzle portion NZ and the like are accommodated is provided in the nozzle tip maintenance portion 45.

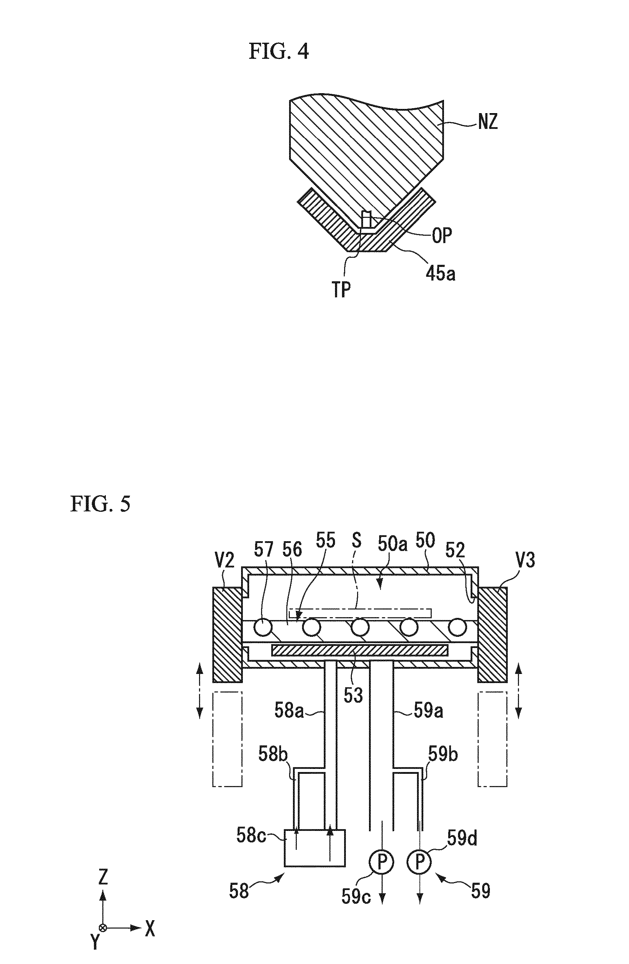

Fig. 4 is a view illustrating a cross-sectional shape of the nozzle portion NZ and the nozzle tip maintenance portion 45. In the cross-sectional view, the wiping portion 45a has a shape which covers the tip TP of the nozzle portion NZ and part of an inclined surface on the tip TP side, as illustrated in Fig. 4.

The guide rail 45b extends in the X direction so as to cover the discharge port OP of the nozzle portion NZ. The wiping portion 45a is movable in the X direction and along the guide rail 45b, by, for example, a driving source (not illustrated). The tip TP is wiped in such a manner that the wiping portion 45a moves, in the X direction, in a state where the wiping portion 45a is in contact with the tip TP of the nozzle portion NZ.

The liquid-body supply portion 33 has a first liquid-body accommodating portion 33a and a second liquid-body accommodating portion 33b. The liquid bodies applied to the substrate S are accommodated in the first liquid-body accommodating portion 33a and the second liquid-body accommodating portion 33b. The first liquid-body accommodating portion 33a and the second liquid-body accommodating portion 33b can receive a different kind of liquid body.

The cleaning solution which is used for cleaning each part of the coating application portion CT, specifically, an inner portion of the nozzle portion NZ, the nozzle tip maintenance portion 45, and the like, is accommodated in the cleaning solution supply portion 34. The cleaning solution supply portion 34 is connected to the inner portion of the nozzle portion NZ, the nozzle tip maintenance portion 45, and the like, through, for example, piping, and a pump (not illustrated).

The waste liquid storage portion 35 collects part of the liquid discharged through the nozzle portion NZ, which is not reused. In addition, the nozzle tip maintenance portion 45 may have a configuration in which a portion for performing a preliminary discharge operation and a portion for cleaning the tip TP of the nozzle portion NZ are separately provided. A preliminary discharge operation may be performed in the nozzle waiting portion 44.

The gas supply/discharge portion 37 has a gas supply portion 37a and a gas exhaust portion 37b. The gas supply portion 37a supplies, to the treatment chamber 20a, an inert gas, such as a nitrogen gas and an argon gas. The gas exhaust portion 37b sucks the gas in the treatment chamber 20a and exhausts, to the outside of the first chamber CB1, the gas in the treatment chamber 20a.

The substrate transport portion 25 transports the substrate S in the treatment chamber 20a. The substrate transport portion 25 has a plurality of rollers 27. Two rows of the rollers 27 are disposed in a state where the two rows cross, in the X direction, the central portion of the treatment chamber 20a in the Y direction. The rollers 27 arranged in the respective rows support a +Y side end portion and a -Y side end portion of the substrate S.

In a state where the rollers 27 support the substrate S, the respective rollers 27 rotate about the Y axis, in the clockwise direction or in the counter-clockwise direction. Therefore, the substrate S supported by the respective rollers 27 is transported in the X direction (the +X direction or the -X direction). A floating transport portion (not illustrated) which transports a substrate in a floating manner may be used for performing a substrate transporting operation.

### Connection Portion

The connection portion CN connects the first chamber CB1 and the second chamber CB2. The substrate S moves, through the connection portion CN, between the first chamber CB1 and the second chamber CB2. The connection portion CN has a third chamber CB3. The third chamber CB3 is formed in a rectangular box shape. A treatment chamber 50a is formed in the third chamber CB3. In the embodiment, a vacuum drying portion VD is provided in the treatment chamber 50a. The vacuum drying portion VD dries the liquid body applied onto the substrate S. Gate valves V2 and V3 are provided in the third chamber CB3.

The third chamber CB3 has a first opening portion 51 and a second opening portion 52. The first opening portion 51 and the second opening portion 52 cause the treatment chamber 50a to communicate with the outside of the third chamber CB3. The first opening portion 51 is formed on the -X side surface of the third chamber CB3. The second opening portion 52 is formed on the +X side surface of the third chamber CB3. The first opening portion 51 and the second opening portion 52 are formed in a size allowing the substrate S to pass therethrough. The substrate S is put in/out to/from the third chamber CB3 through the first opening portion 51 and the second opening portion 52.

The vacuum drying portion VD has a substrate transport portion 55, a gas supply portion 58, a gas exhaust portion 59, and a heating portion 53.

The substrate transport portion 55 has a plurality of rollers 57. The rollers 57 are arranged in the Y direction to form a pair and a plurality of the pairs of the rollers 57 are aligned in the X direction. The plurality of the rollers 57 support the substrate S which passes through the first opening portion 51 and is disposed in the treatment chamber 50a.

In a state where the rollers 57 support the substrate S, the respective rollers 57 rotate about the Y axis, in the clockwise direction or in the counter-clockwise direction. Therefore, the substrate S supported by the respective rollers 57 is transported in the X direction (the +X direction or the -X direction). A floating transport portion (not illustrated) which transports a substrate in a floating manner may be used for performing a substrate transporting operation.

Fig. 5 is a schematic view illustrating the configuration of the vacuum drying portion VD.

The gas supply portion 58 supplies, to the treatment chamber 50a, an inert gas, such as a nitrogen gas and an argon gas, as illustrated in Fig. 5. The gas supply portion 58 has a first supply portion 58a and a second supply portion 58b. The first supply portion 58a and the second supply portion 58b are connected to a gas supply source 58c, such as a gas cylinder and a gas pipe. Supply of gas to the treatment chamber 50a is mainly performed using the first supply portion 58a. The second supply portion 58b performs a fine adjustment of an amount of gas supplied by the first supply portion 58a.

The gas exhaust portion 59 sucks the gas in the treatment chamber 50a and exhausts, to the outside of the third chamber CB3, the gas in the treatment chamber 50a. Therefore, the gas exhaust portion 59 reduces the pressure in the treatment chamber 50a. The pressure in the treatment chamber 50a is reduced, and thus evaporation of a solvent which is contained in the liquid body on the substrate S is promoted. Accordingly, the liquid body is dried. The gas exhaust portion 59 has a first suction portion 59a and a second suction portion 59b. The first suction portion 59a and the second suction portion 59b are connected to suction sources 59c and 59d, such as a pump. Suction from the treatment chamber 50a is mainly performed using the first suction portion 59a. The second suction portion 59b performs a fine adjustment of an amount of gas sucked by the first suction portion 59a.

The heating portion 53 heats the liquid body on the substrate S which is disposed in the treatment chamber 50a. An infrared device or a hot plate, for example, is used as the heating portion 53. The temperature of the heating portion 53 can be adjusted, for example, in the range between room temperature and about 100°C. The heating portion 53 is provided, and thus the evaporation of the solvent which is contained in the liquid body on the substrate S is promoted. Therefore, a drying treatment under a depressurized state is supported.

The heating portion 53 is connected to a lifting mechanism (a movement portion) 53a. The lifting mechanism 53a moves the heating portion 53 in the Z direction. A motor mechanism or an air cylinder mechanism, for example, is used as the lifting mechanism 53a. The lifting mechanism 53a moves the heating portion 53 in the Z direction, and thus a distance between the heating portion 53 and the substrate S can be adjusted. A movement amount, a movement timing, and the like of the heating portion 53 by the lifting mechanism 53a, are controlled by the control portion CONT.

### Second Chamber

The second chamber CB2 is disposed on the base stage BB mounted on the floor surface FL. The second chamber CB2 is formed in a rectangular box shape. A treatment chamber 60a is formed in the second chamber CB2. The baking portion BK is provided in the treatment chamber 60a. The baking portion BK bakes a coating film coated on the substrate S.

The baking portion BK has a substrate transport portion 65, a gas supply portion 68, a gas exhaust portion 69, and a chamber apparatus 70.

The substrate transport portion 65 has a plurality of rollers 67 and an arm portion 71. A pair of the rollers 67 is arranged in a state where the substrate guide stage 66 is interposed, in the Y direction, between the pair of the rollers 67, and a plurality of the pairs of the rollers 67 are aligned in the X direction. The plurality of the rollers 67 support the substrate S which passes through the opening portion 61 and is disposed in the treatment chamber 60a.

In a state where the plurality of the rollers 67 support the substrate S, each roller 67 rotates about the Y axis, in the clockwise direction or in the counter-clockwise direction. Therefore, the substrate S supported by the rollers 67 is transported in the X direction (the +X direction or the -X direction). A floating transport portion (not illustrated) which transports a substrate in a floating manner may be used for performing a substrate transporting operation.

The arm portion 71 is disposed on the base stand 74 and performs transferring of the substrate S between the plurality of the rollers 67 and the chamber apparatus 70. The arm portion 71 has a transport arm 72 and an arm driving portion 73. The transport arm 72 has a substrate support portion 72a and a movement portion 72b. The substrate support portion 72a supports the +Y side and the -Y side of the substrate S. The movement portion 72b is connected to the substrate support portion 72a. The movement portion 72b can move in the X direction and can pivot in a θZ direction.

The arm driving portion 73 drives the movement portion 72b to move in the X direction or in the θZ direction. When the arm driving portion 73 moves the movement portion 72b in the +X direction, the substrate support portion 72a is inserted into the chamber apparatus 70 and the substrate S is disposed, when viewed from the Z direction, in a central portion of the chamber apparatus 70.

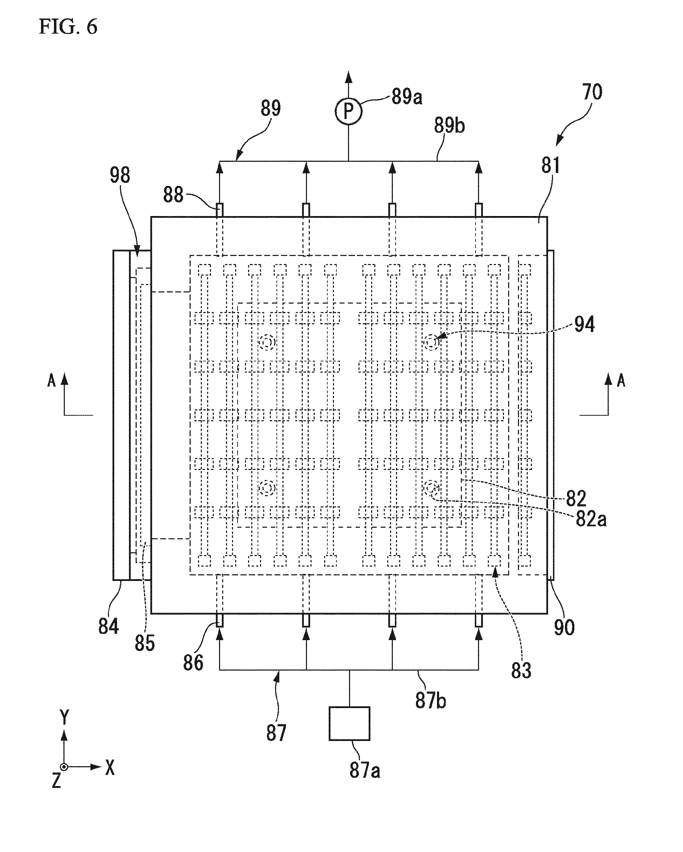

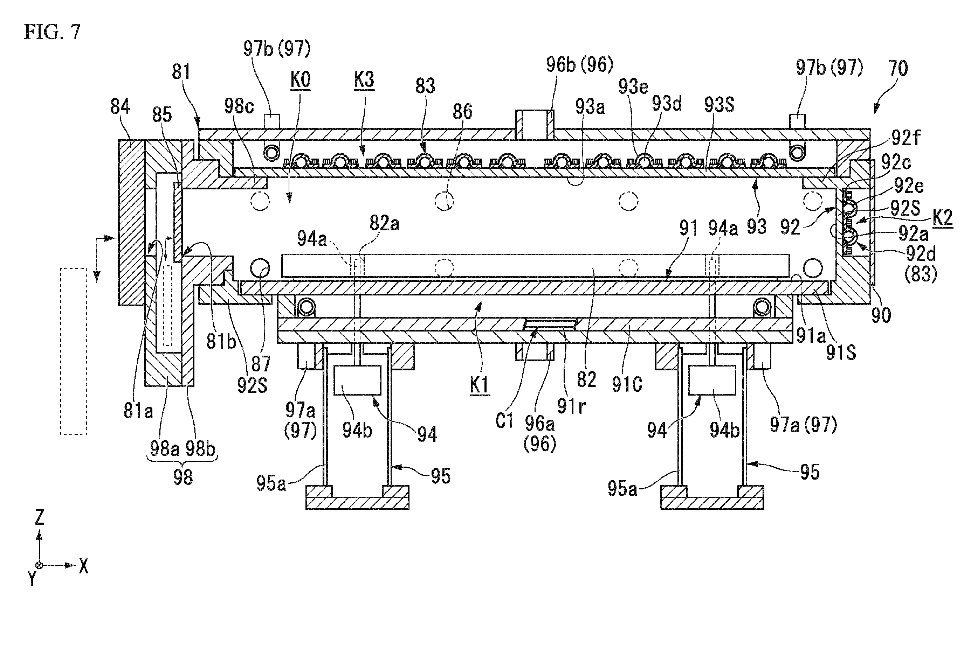

Fig. 6 is a plan view illustrating the configuration of the chamber apparatus 70. Fig. 7 is a cross-sectional view illustrating the configuration of the chamber apparatus 70, taken along line A-A in Fig. 6.

The chamber apparatus 70 is disposed on the base stand 74, as illustrated in Figs. 6 and 7. The chamber apparatus 70 has a chamber main body 81, a heating plate (a heating portion) 82, and a temperature adjustment portion 83.

The chamber main body 81 has a bottom portion 91, lateral wall portions 92, and a ceiling portion 93. The bottom portion 91 and the ceiling portion 93 have a rectangular shape, when viewed in plan view. Four sides of the bottom portion 91 respectively overlap with four sides of the ceiling portion 93. The lateral wall portions 92 are disposed in positions which correspond to four sides of the bottom portion 91 and four sides of the ceiling portion 93. The bottom portion 91, the lateral wall portions 92, and the ceiling portion 93 are disposed to surround an internal space K0 of the chamber main body 81.

The bottom portion 91 has a bottom plate 91 S. A +Z side surface of the bottom plate 91 S is a bottom surface 91a which is formed to be parallel to the XY plane. The posture of the bottom surface 91a is set to be flat, and thus it is possible to minimize the space under the heating plate 82. The bottom surface 91a of the bottom plate 91S supports the heating plate 82. A part of the bottom surface 91a is in contact with the internal space K0. A bottom portion space K1 is formed on the -Z side of the bottom plate 91 S. A mist supply port 96a and an air supply port 97a are provided in the bottom portion space K1.

The bottom portion 91 has a temperature adjustment plate 91C. The temperature adjustment plate 91 C is disposed on the -Z side of the bottom plate 91 S. The temperature adjustment plate 91C is provided in a position in which the bottom portion space K1 is interposed between the temperature adjustment plate 91C and the bottom plate 91 S. A flow path 91 r through which a temperature adjusting medium C1 can flow is formed in the temperature adjustment plate 91 C. The flow path 91 r is drawn over, for example, the entirety of the temperature adjustment plate 91C in a plate surface direction. The flow path 91r is connected to a temperature adjusting medium supply source (not illustrated) which is installed in, for example, an external portion of the temperature adjustment plate 91C. According to the configuration described above, it is possible to adjust the temperature of the bottom plate 91S via the temperature adjustment plate 91C. Since the temperature of the bottom plate 91S is adjusted, it is possible to adjust the temperature of the heating plate 82 supported by the bottom plate 91S. Liquid, such as water, may be used as the temperature adjusting medium C1 or other substance may be used as the temperature adjusting medium C1. Furthermore, the flow path through which the temperature adjusting medium C1 flows may be directly formed in the bottom plate 91S. In addition, the temperature adjusting medium C1 may flow through part of the bottom portion space K1.

The lateral wall portion 92 has a wall member 92S having a rectangular frame shape. The inner surface 92a of the wall member 92S is in contact with the internal space K0. A concave portion 92b is formed on an external surface of one +X side portion among four side portions of the wall member 92S. The concave portion 92b is sealed by a lid member 90. As described above, a wall internal space K2 is formed in the wall member 92S, by the lid member 90 and the concave portion 92b. A plurality of sheath heaters 92d are provided, as the temperature adjustment portion 83, in the wall internal space K2. The sheath heater 92d is fixed to the wall member 92S, using a fastener 92e. Since the plurality of sheath heaters 92d are provided, the temperature of the inner surface 92a can be regulated by the plurality of sheath heaters 92d, from an inner side of the lateral wall portion 92. In addition, although Figs. 6 and 7 exemplify a configuration in which the sheath heater 92d is installed in only one +X side portion of the four side portions of the wall member 92S, the configuration is not limited thereto. The sheath heater 92d may be installed in at least one side portion of the other three side portions.

An opening mechanism 98 is provided on one -X side portion of the four side portions of the wall member 92S. The opening mechanism 98 has a first member 98a in which the first opening portion 81a is formed, a second member 98b in which a second opening portion 81b is formed, a first opening/closing member 84 which opens/closes the first opening portion 81a, and a second opening/closing member 85 which opens/closes the second opening portion 81b.

The first member 98a is disposed on an outer side of the chamber main body 81. The second member 98b is disposed on an inner side of the chamber main body 81. The second member 98b is inserted into a part of the wall member 92S, which is formed on the -X side. A protrusion portion 98c is formed on an upper side of the second member 98b.

The first opening portion 81a and the second opening portion 81b are provided such that the inside and the outside of the chamber main body 81 communicate with each other. The first opening portion 81 a of the two opening portions is disposed on an outer side. The first opening portion 81a can be opened/closed by the first opening/closing member 84. The second opening portion 81b of the two opening portions is disposed on an inner side. The second opening portion 81b can be opened/closed by the second opening/closing member 85. The first opening portion 81a and the second opening portion 81b function as carry-in/carry-out ports for carrying in and carrying out the substrate S. The first opening/closing member 84 and the second opening/closing member 85 can move to positions separate from opening areas of the first opening portion 81a and the second opening portion 81 b, so as not to hinder transporting of the substrate S.

A gas introduction port 86 is provided on one -Y side portion of the four side portions of the wall member 92S. The gas introduction port 86 is connected to a gas supply portion 87 illustrated in Fig. 6. The gas introduction port 86 supplies, for example, a nitrogen gas to the internal space K0. The gas supply portion 87 has a gas supply source 87a, such as a bombe and a gas pipe, and a connection pipe 87b which connects the gas supply source 87a and the gas introduction port 86. The gas supply source 87a has a nitrogen gas supply source and a supply source of gas (for example, hydrogen sulfide, and hydrogen selenide) containing chalcogen elements. The gas supply source 87a may have another gas supply source.

A gas exhaust port 88 is provided on one +Y side portion of the four side portions of the wall member 92S. A gas exhaust port 88 is connected to a gas exhaust portion 89 illustrated in Fig. 6. The gas exhaust portion 89 sucks the gas in the internal space K0 and exhausts, to the outside of the internal space K0, the gas in the internal space K0. The gas exhaust portion 89 has a suction source 89a, such as a pump, and a connection pipe 89b which connects the suction source 89a and the gas exhaust port 88.

As described above, in the wall member 92S, the gas introduction port 86 is provided in one side portion of two side portions which face in the Y direction and the gas exhaust port 88 is provided in the other side portion. Thus, there is an advantage in that it is easy to form a flow of gas introduced into the internal space K0. In the embodiment, a configuration in which the gas introduction port 86 is connected to an upper side of the internal space K0 and the gas exhaust port 88 is connected to a lower side of the internal space K0 is exemplified. However, the configuration is not limited thereto. For example, the gas introduction port 86 and the gas exhaust port 88 may be arranged in a state where the Z directional positions thereof are set to be the same. Furthermore, with regard to the X directional arrangement of a plurality of the gas introduction port 86 and the gas exhaust ports 88, a pitch, and an arrange pattern, for example, may be appropriately set. In addition, the gas supply portion 87 may have a heating portion (not illustrated) for heating gas or the gas exhaust portion 89 may have a heating portion (not illustrated) for heating gas.

The ceiling portion 93 has a ceiling plate 93S. The ceiling plate 93S is fixed to a protrusion portion 92f of the wall member 92S and the protrusion portion 98c of the second member 98b. The protrusion portion 92f is a part of the wall member 92S, which protrudes to the internal space K0 side. A-Z side surface of the ceiling plate 93S is a ceiling surface 93a which is formed to be parallel to the XY plane. The ceiling surface 93a is a surface in contact with the internal space K0. The +Z side of the ceiling plate 93S is a ceiling space K3. A plurality of the sheath heaters 93d are provided, as the temperature adjustment portion 83, in the ceiling space K3. The plurality of sheath heaters 93d are aligned in the X direction at predetermined intervals. The sheath heater 93d is fixed to the +Z side surface of the ceiling plate 93S, using a fastener 93e. In this configuration, the temperature of the ceiling surface 93a can be adjusted, by the plurality of sheath heaters 93d, from an inner side of the ceiling portion 93. The sheath heaters 93d are disposed over the entirety of the ceiling surface 93a, as illustrated in Fig. 6, and thus it is possible to evenly adjust the temperature of the ceiling surface 93a. A mist supply port 96b and an air supply port 97b are provided in the ceiling space K3. The mist supplied through the mist supply port 96b and the air supplied through the air supply port 97b are used for, for example, controlling (for example, cooling) the temperature of the sheath heater 93d.

The heating plate 82 is disposed in the internal space K0 and is fixed to the bottom plate 91S of the bottom portion 91 as described above. The heating plate 82 heats the substrate S, in a state where the substrate S is mounted on the heating plate 82. The heating plate 82 is constituted by, for example, quartz. A heating device, such as an infrared device and a hot plate, is provided in the heating plate 82. The temperature of the heating plate 82 can be adjusted in the range between, for example, approximately, 200°C and 800°C. A plurality of through holes 82a are formed in the heating plate 82. The through holes 82a allow a part of a lift portion 94 to pass therethrough.

The lift portion 94 causes the substrate S to move between the arm portion 71 and the heating plate 82. The lift portion 94 has a plurality of support pins 94a and a movement portion 94b which holds the support pin 94a and can move in the Z direction. The plurality of through holes 82a provided in the heating plate 82 are arranged in positions which correspond, when viewed in the Z direction, to the plurality of the support pins 94a. A cover portion 95 which covers a movement path of the support pin 94a and the movement portion 94b is provided in the lift portion 94. The cover portion 95 has a heating portion 95a which heats a surface of the cover portion 95.

### Substrate Transport Path

The second opening portion 12 of the substrate supplying/collecting portion LU, the first opening portion 21 and the second opening portion 22 of the coating application portion CT, the first opening portion 51 and the second opening portion 52 of the vacuum drying portion VD, and the opening portion 61 of the baking portion BK are aligned along a straight line parallel to the X direction. Thus, the substrate S moves along a straight line extending in the X direction. Furthermore, in a path in which the substrate is transported from the substrate supplying/collecting portion LU to the chamber apparatus 70 of the baking portion BK, the Z directional position is held. Therefore, ambient gas is prevented from being agitated by the substrate S.

### Antichamber

Antichambers AL to AL3 are connected to the first chamber CB1, as illustrated in Fig. 1.

The antichambers AL1 to AL3 are provided in a state where the respective antichambers AL1 to AL3 communicate with the outside and an inner side of the first chamber CB1. The respective antichambers AL1 to AL3 are paths which are used for putting out a component of the treatment chamber 20a to the outside of the first chamber CB1 and for putting in the component from the outside of the first chamber CB1 to the treatment chamber 20a.

The antichamber AL1 is connected to the discharge portion 31. The nozzle portion NZ provided in the discharge portion 31 can be put out/in from/to the treatment chamber 20a, through the antichamber AL1. The antichamber AL2 is connected to the liquid-body supply portion 33. The liquid-body supply portion 33 can be put out/in from/to the treatment chamber 20a, through the antichamber AL2.

The antichamber AL3 is connected to a liquid-body preparation potion 36. In the liquid-body preparation potion 36, the liquid body can be put in/out to/from the treatment chamber 20a, through the antichamber AL3. Furthermore, the antichamber AL3 is formed in a size allowing the substrate S to pass therethrough. Thus, when, for example, test coating of the liquid body is performed in the coating application portion CT, the substrate S not subjected to a treatment can be supplied to the treatment chamber 20a, through the antichamber AL3. In addition, the substrate S subjected to the test coating can be put out through the antichamber AL3. Furthermore, in case of emergency, the substrate S can be temporarily put out through the antichamberAL3.

The antichamber AL4 is connected to the second chamber CB2.

The antichamber AL4 is connected to the chamber apparatus 70. The antichamber AL4 is formed in a size allowing the substrate S to pass therethrough. Thus, when, for example, heating of the substrate S is performed in the chamber apparatus 70, it is possible to supply the substrate S from the antichamber AL4 to the treatment chamber 60a. In addition, the substrate S subjected to the heating treatment can be put out through the antichamberAL4.

### Glove Portion

A glove portion GX1 is connected to the first chamber CB1, as illustrated in Fig. 1. In addition, a glove portion GX2 is connected to the second chamber CB2.

The glove portion GX1 and the glove portion GX2 are portions through which an operator accesses the first chamber CB1 and the treatment chamber 60a. An operator can perform a maintenance operation in the first chamber CB1 and the treatment chamber 60a in such a manner that the operator inserts his or her hand into the glove portion GX1 or the glove portion GX2. The glove portions GX1 and GX2 are formed in a bag shape. The glove portions GX1 and GX2 are disposed in a plurality of positions around the first chamber CB1 and the treatment chamber 60a. For example, sensors for detecting whether or not an operator inserts his or her hand into the glove portions GX1 and GX2 may be disposed in the first chamber CB1 and the treatment chamber 60a.

### Gate Valve

A gate valve V1 is provided in a portion between the second opening portion 12 of the substrate supplying/collecting portion LU and the first opening portion 21 of the coating application portion CT. The gate valve V1 can move in the Z direction by a driving portion (not illustrated). The second opening portion 12 of the substrate supplying/collecting portion LU and the first opening portion 21 of the coating application portion CT can be opened or closed at the same time, in such a manner that the gate valve V1 moves in the Z direction. When the second opening portion 12 and the first opening portion 21 are opened at the same time, the substrate S can move between the second opening portion 12 and the first opening portion 21.

A gate valve V2 is provided in a portion between the second opening portion 22 of the first chamber CB1 and the first opening portion 51 of the third chamber CB3. The gate valve V2 can move in the Z direction by a driving portion (not illustrated). The second opening portion 22 of the first chamber CB1 and the first opening portion 51 of the third chamber CB3 can be opened or closed at the same time, in such a manner that the gate valve V2 moves in the Z direction. When the second opening portion 22 and the first opening portion 51 are opened at the same time, the substrate S can move between the second opening portion 22 and the first opening portion 51.

A gate valve V3 is provided in a portion between the second opening portion 52 of the third chamber CB3 and the opening portion 61 of the second chamber CB2. The gate valve V3 can move in the Z direction by a driving portion (not illustrated). The second opening portion 52 of the third chamber CB3 and the opening portion 61 of the second chamber CB2 can be opened or closed at the same time, in such a manner that the gate valve V3 moves in the Z direction. When the second opening portion 52 and the opening portion 61 are opened at the same time, the substrate S can move between the second opening portion 52 and the opening portion 61.

### Control Device

The control portion CONT is a portion which generally controls the coating applicator CTR. Specifically, the control portion CONT controls operations in the substrate supplying/collecting portion LU, the coating application portion CT, the vacuum drying portion VD, and the baking portion BK, operations of the gate valves V1 to V3, and the likes. As an example of an adjustment operation, the control portion CONT adjusts a supply amount of the gas supply portion 37a, based on detection results by solvent concentration sensors SR1 to SR4. The control portion CONT has, for example, a timer (not illustrated) used for measuring a treatment period.

### Coating Application Method

Next, a coating application method according to the embodiment will be described. In the embodiment, a coating film containing metal is formed on the substrate S, using the coating applicator CTR configured as described above. Operations performed in each portion of the coating applicator CTR are controlled by the control portion CONT.

The control portion CONT causes the substrate S to be carried from the outside to the substrate supplying/collecting portion LU. In this case, the control portion CONT causes the gate valve V1 to be closed and causes the lid portion 14 to be opened, and then the control portion CONT causes the substrate S to be accommodated in the accommodation chamber 10a of the chamber 10. After the substrate S is accommodated in the accommodation chamber 10a, the control portion CONT causes the lid portion 14 to be closed.

After the lid portion 14 is closed, the control portion CONT causes the gate valve V1 to be opened, such that the accommodation chamber 10a of the chamber 10 communicates with the treatment chamber 20a of the first chamber CB1 of the coating application portion CT. After the gate valve V1 is opened, the control portion CONT causes the substrate S to be transported, using the substrate transport portion 15, in the X direction.

After a part of the substrate S is inserted in the treatment chamber 20a of the first chamber CB1, the control portion CONT causes the substrate S to be completely carried in to the treatment chamber 20a, using the substrate transport portion 25. After the substrate S is transported to the treatment chamber 20a, the control portion CONT causes the gate valve V1 to be closed. After the gate valve V1 is closed, the control portion CONT causes the substrate S to be transported to the treatment stage 28.

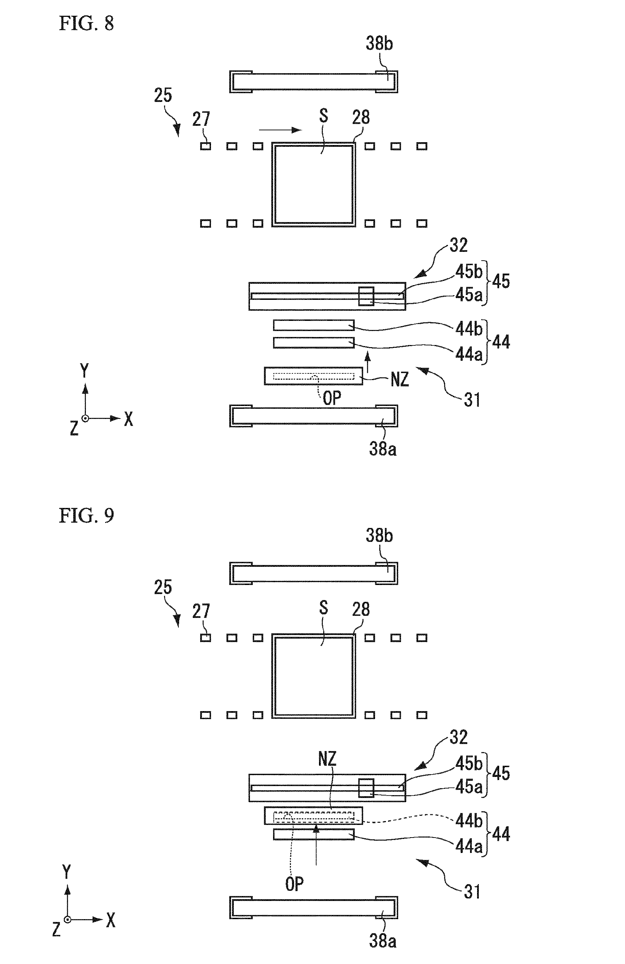

Fig. 8 is a view illustrating a simplified configuration of the coating application portion CT, in which a part of the configuration thereof is not illustrated. Figs. 9 to 12 illustrate the same. When the substrate S is mounted on the treatment stage 28, a coating treatment is performed in the coating application portion CT, as illustrated in Fig. 8. Prior to the coating treatment, the control portion CONT causes the gate valves V1 and V2 to be closed and performs supply and suction of an inert gas, using the gas supply portion 37a and the gas exhaust portion 37b.

Accordingly, the atmosphere and the pressure in the treatment chamber 20a are adjusted. After the atmosphere and the pressure in the treatment chamber 20a are adjusted, the control portion CONT causes the nozzle portion NZ to move from the nozzle waiting portion 44 to the nozzle tip maintenance portion 45, using the nozzle driving portion NA (not illustrated in Fig. 8). During the subsequent coating treatment, the control portion CONT causes an operation for adjusting the atmosphere and the pressure in the treatment chamber 20a to be continuously performed.

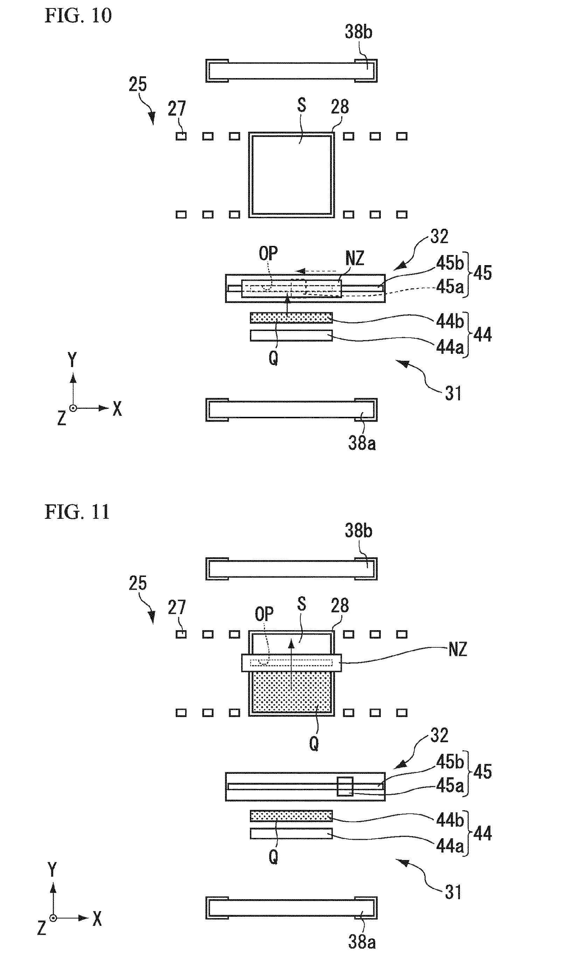

After the nozzle portion NZ reaches the nozzle tip maintenance portion 45, the control portion CONT causes the nozzle portion NZ to perform a preliminary discharging operation, as illustrated in Fig. 9. In the preliminary discharging operation, the control portion CONT causes a liquid body Q to be discharged through the discharge port OP. After the preliminary discharging operation is performed, the control portion CONT causes the wiping portion 45a to move, in the X direction, along the guide rail 45b, so as to wipe the tip TP of the nozzle portion NZ and the inclined portion in the vicinity of the tip TP, as illustrated in Fig. 10.

After the tip TP of the nozzle portion NZ is wiped, the control portion CONT causes the nozzle portion NZ to move to the treatment stage 28. After the discharge port OP of the nozzle portion NZ reaches the -Y side end portion of the substrate S, the control portion CONT causes the nozzle portion NZ to move in the +Y direction at a predetermined speed and causes the liquid body Q to be discharged onto the substrate S through the discharge port OP, as illustrated in Fig. 11. Accordingly, a coating film F of the liquid body Q is formed on the substrate S.

After the coating film of the liquid body Q is formed on a predetermine area of the substrate S, the control portion CONT causes the substrate S to move, in the +X direction, from the treatment stage 28 to a second stage 26B, using the substrate transport portion 25. In addition, the control portion CONT causes the nozzle portion NZ to move in the -Y direction, and thus the nozzle portion NZ returns to the nozzle waiting portion 44.

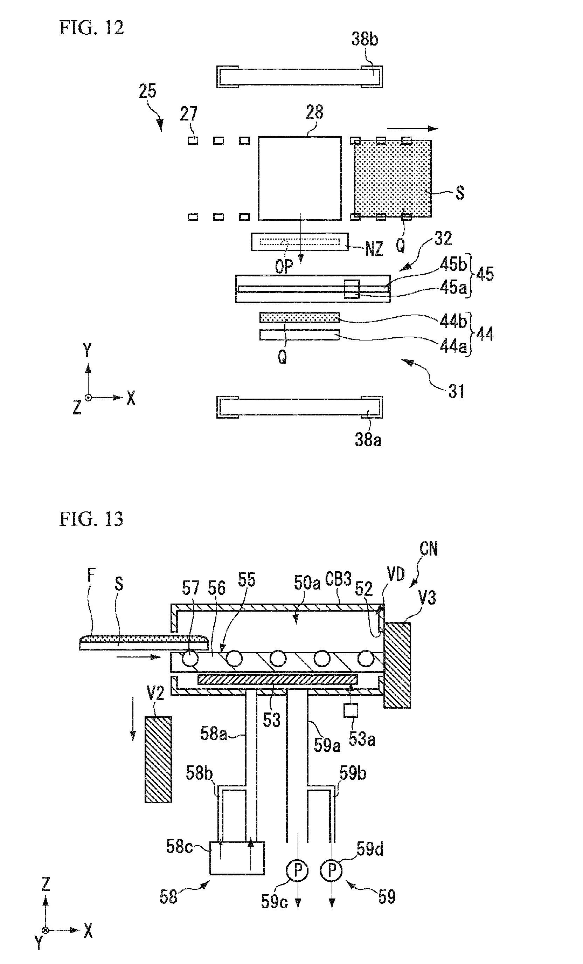

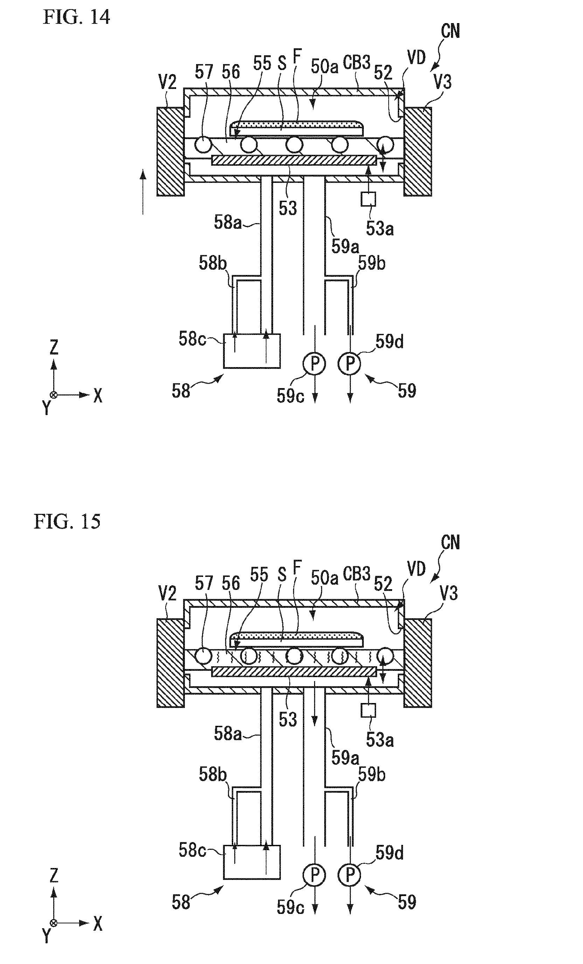

After the substrate S reaches the second opening portion 22 of the first chamber CB1, the control portion CONT causes the gate valve V2 to be opened and causes the substrate S to be transported from the first chamber CB1 to the second chamber CB2, as illustrated in Fig. 13. When the transport step is performed, the substrate S passes through the third chamber CB3 disposed in the connection portion CN. When the substrate S passes through the third chamber CB3, the control portion CONT causes the vacuum drying portion VD to perform a drying treatment on the substrate S. Specifically, after the substrate S is accommodated in the treatment chamber 50a of the third chamber CB3, the control portion CONT causes the gate valve V2 to be closed, as illustrated in Fig. 14.

After the gate valve V2 is closed, the control portion CONT causes the lifting mechanism 53a to adjust the Z directional position of the heating portion 53. Then, the control portion CONT causes the gas supply portion 58 to adjust the atmosphere in the treatment chamber 50a and causes the gas exhaust portion 59 to reduce the pressure in the treatment chamber 50a, as illustrated in Fig. 15. Accordingly, the pressure in the treatment chamber 50a is reduced, and thus evaporation of the solvent contained in the coating film of the liquid body Q formed on the substrate S is promoted. As a result, the coating film is dried. During the pressure reducing operation in which the pressure in the treatment chamber 50a is reduced by the gas exhaust portion 59, the control portion CONT may cause the lifting mechanism 53a to adjust the Z directional position of the heating portion 53.

In addition, the control portion CONT heats the coating film F on the substrate S, using the heating portion 53, as illustrated in Fig. 15. Evaporation of the solvent contained in the coating film F on the substrate S is promoted by this operation, and thus it is possible to perform the drying treatment under the depressurized state, in a short time. During the hearing operation by the heating portion 53, the control portion CONT may cause the lifting mechanism 53a to adjust the Z directional position of the heating portion 53.

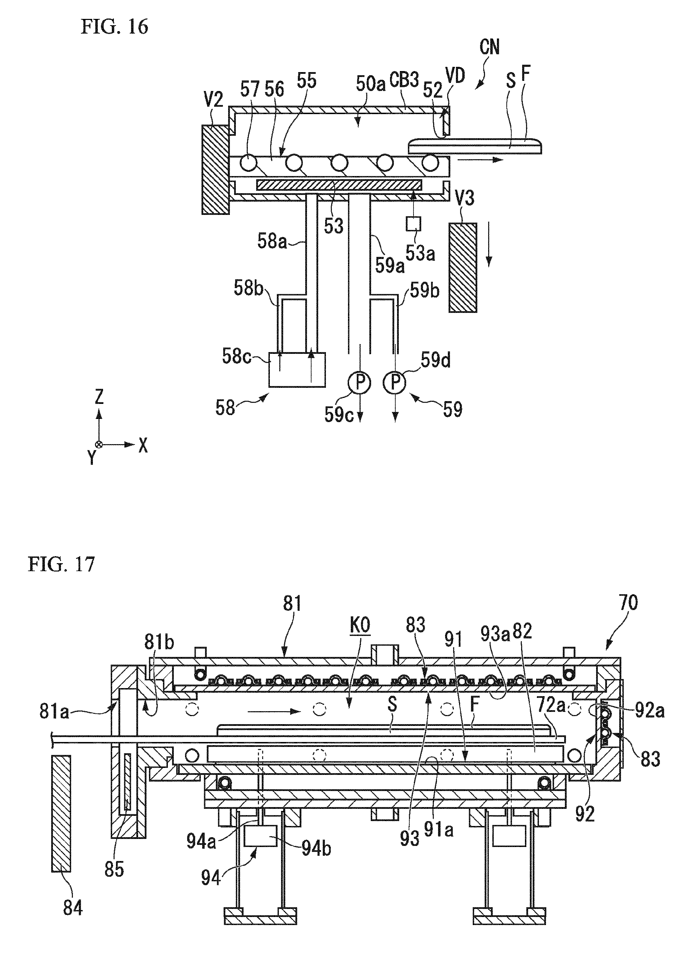

After the vacuum drying treatment is performed, the control portion CONT causes the gate valve V3 to be opened and causes the substrate S to be transported from the connection portion CN to the second chamber CB2, as illustrated in Fig. 16. After the substrate S is accommodated in the treatment chamber 60a of the second chamber CB2, the control portion CONT causes the gate valve V3 to be closed.

The control portion CONT causes the first opening/closing member 84 and the second opening/closing member 85 to move such that the first opening portion 81a and the second opening portion 81b are opened, as illustrated in Fig. 17. Subsequently, the control portion CONT causes the substrate support portion 72a to move in the +X direction, and thus the substrate S passes through the first opening portion 81a and the second opening portion 81b and is inserted in the internal space K0. As a result, the substrate S is disposed on the heating plate 82.

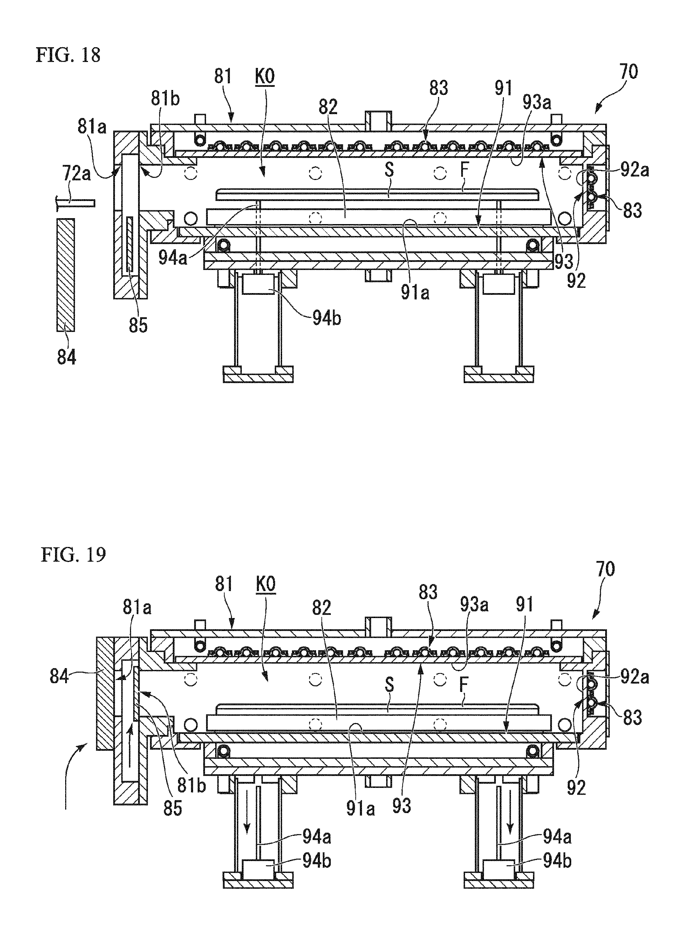

Next, the control portion CONT causes the lift portion 94 to move in the +Z direction, as illustrated in Fig. 18. Accordingly, the substrate S is separated from the substrate support portion 72a of the transport arm 72 and is supported by the plurality of support pins 94a of the lift portion 94. In this way, the substrate S is handed over from the substrate support portion 72a to the lift portion 94. After the substrate S is supported by the support pins 94a of the lift portion 94, the control portion CONT causes the substrate support portion 72a to retreat, in the -X direction, to the outside of the chamber apparatus 70.

After the substrate support portion 72a retreats, the control portion CONT causes the lift portion 94 to move in the -Z direction and causes the first opening/closing member 84 and the second opening/closing member 85 to move so as to close the first opening portion 81a and the second opening portion 81b, as illustrated in Fig. 19. Accordingly, the internal space K0 of the chamber main body 81 is sealed. After the internal space K0 is sealed, the control portion CONT causes the lift portion 94 to move in the -Z direction, and thus the substrate S is mounted on the heating plate 82. In this way, the substrate S is accommodated in the internal space K0 (an accommodation step).

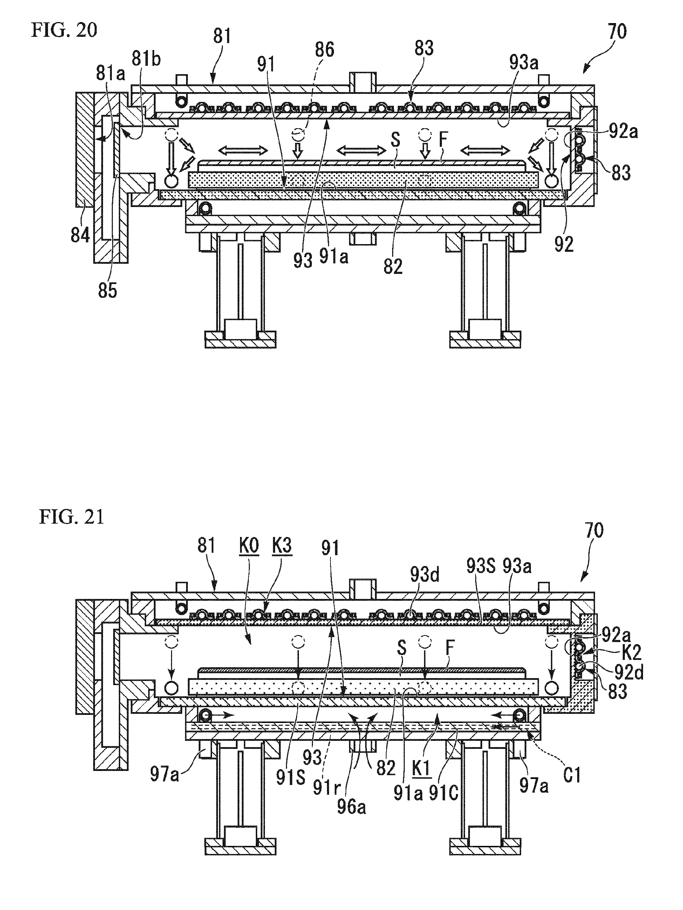

After the substrate S is accommodated in the internal space K0, the control portion CONT causes the gas supply portion 87 to supply a nitrogen gas, a hydrogen sulfide gas, and a hydrogen selenide gas to the internal space K0, as illustrated in Fig. 20 and causes the gas exhaust portion 89 to suck the gas in the internal space K0. Accordingly, the atmosphere and the pressure in the internal space K0 are adjusted and airflows of a nitrogen gas, a hydrogen sulfide gas, and a hydrogen selenide gas are formed in the internal space K0. In a state where the airflows of a nitrogen gas, a hydrogen sulfide gas, and a hydrogen selenide gas are formed, the control portion CONT causes the heating plate 82 to operate, and thus the baking operation of the substrate S is performed (a heating step). Accordingly, the solvent component is evaporated from the coating film F of the substrate S and, for example, air bubbles in the coating film F are removed. In addition, for example, the solvent component and the air bubbles evaporated from the coating film F are blown away by the airflows of a nitrogen gas, a hydrogen sulfide gas, and a hydrogen selenide gas. Then, the solvent component, the air bubbles, and the likes are sucked away by the gas exhaust portion 89.

In the baking operation, at least one kind of metal components contained in the coating film F is heated to the melting point or higher, and thus at least a part of the coating film F is melted. In a case where the coating film F is used for, for example, a CZTS type solar cell, Ti, S, and Se of components constituting the coating film F are heated to the melting point or higher. Accordingly, the components described above are liquefied and the coating film F is aggregated. Next, the coating film F is cooled to the temperature at which the coating film F is solidified. The coating film F is solidified, and thus the hardness of the coating film F can be increased.

After the baking operation described above is finished, the control portion CONT causes the operation of the heating plate 82 to be stopped, and thus the temperatures of the substrate S and the chamber main body 81 are lowered. In this case, a vaporized substance, such as metal components vaporized in the heating step, may not be exhausted and remain in the internal space K0. Thus, when the temperatures of the substrate S and the chamber main body 81 are naturally cooled, the vaporized substance remaining in the internal space K0 is cooled and solidified. Thus, there is a concern that the vaporized substance may adhere to an inner portion of the chamber main body 81.

To prevent the problem described above, the control portion CONT causes the temperature adjustment portion 83 to adjust the temperature of a part of the chamber main body 81, which is in contact with the internal space K0, as illustrated in Fig. 21. Examples of a part of the chamber main body 81, which is in contact with the internal space K0, include the inner surface 92a of the lateral wall portion 92, and the ceiling surface 93a of the ceiling portion 93. In the lateral wall portion 92, the control portion CONT causes the sheath heater 92d to heat the wall member 92S. Accordingly, the inner surface 92a is heated from an inner portion of the lateral wall portion 92. In the ceiling portion 93, the control portion CONT causes the sheath heater 93d to heat the ceiling plate 93S. Thus, the ceiling surface 93a is heated from an inner portion of the ceiling portion 93.

Since, the inner surface 92a and the ceiling surface 93a are heated by the sheath heaters 92d and 93d respectively, the inner surface 92a and the ceiling surface 93a are prevented from decreasing in temperature. Therefore, it is possible to prevent the vaporized substance remaining in the internal space K0 from being solidified, and thus it is possible to prevent adhesion of the metal substance or the like.

In addition to the temperature adjustment by the temperature adjustment portion 83 described above, the control portion CONT causes the temperature adjusting medium C1 to flow through the flow path 91 in the temperature adjustment plate 91C, and thus the temperature adjustment plate 91C is cooled. Therefore, the bottom plate 91 S and the heating plate 82 mounted on the bottom plate 91 S are cooled, and thus the substrate S is cooled via the heating plate 82. Since the substrate S is cooled, the vaporized substance remaining in the internal space K0 is cooled by the substrate S and solidified. As a result, the vaporized substance adheres to the substrate S. Then, the substrate S is carried out from the internal space K0. Thus, the vaporized substance in the internal space K0 is discharged in a state where the vaporized substance adheres to the substrate S. Therefore, the total amount of the vaporized substance existing in the internal space K0 is reduced.

In a case where the inner surface 92a and the ceiling surface 93a is heated and the substrate S is cooled, as described above, the internal space K0 is cleaned in such a manner that the control portion CONT causes an inert gas, such as nitrogen, to be supplied to the internal space K0 through the gas introduction port 86 and causes the gas in the internal space K0 to be exhausted through the gas exhaust port 88, as illustrated in Fig. 21. Therefore, the total amount of the vaporized substance existing in the internal space K0 is reduced.

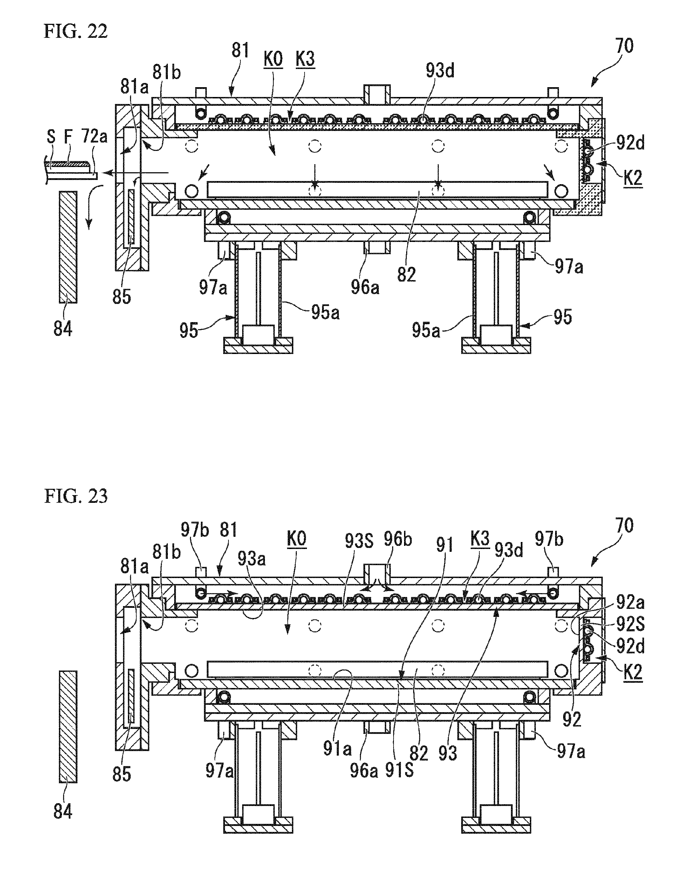

After the temperature of the substrate S is reduced to a predetermined temperature, the substrate S is carried out from the internal space K0. The control portion CONT causes the first opening/closing member 84 and the second opening/closing member 85 to move, such that the first opening portion 81a and the second opening portion 81b are opened, as illustrated in Fig. 22. Furthermore, the control portion CONT causes the lift portion 94 to move in the +Z direction, and thus the substrate S is lifted by the support pins 94a. Then, the control portion CONT causes the substrate support portion 72a of the transport arm 72 to be inserted in the internal space K0, and thus the substrate S is supported by the substrate support portion 72a. After the substrate S is supported by the substrate support portion 72a, the control portion CONT causes the substrate support portion 72a to move in the -X direction. Accordingly, the substrate S is carried out from the internal space K0. In addition, when the substrate S is carried out, the control portion CONT causes the temperature adjustment portion 83 to maintain heating of the inner surface 92a and the ceiling surface 93a and maintains exhaust of gas through the gas exhaust port 88. Accordingly, solidification of the vaporized substance is prevented when the substrate is carried out and the vaporized substance existing in the internal space K0 is exhausted.

After the substrate is carried out, the control portion CONT causes the temperature adjustment portion 83 to stop the heating operation, and thus the chamber main body 81 is cooled, as illustrated in Fig. 23. In this case, it is possible to cool the sheath heater 92d in such a manner that mist is supplied to the ceiling space K3 through the mist supply port 96b and air is supplied to the ceiling space K3 through the air supply port 97b. In the heating step described above, the vaporized substance existing in the internal space K0 is exhausted without being solidified, and thus the chamber main body 81 is cooled in a state where metal substance or the like rarely adheres to the inner surface 92a, the ceiling surface 93a, the bottom surface 91a, or the like. As a result, the substrate S which is subsequently carried in is accommodated in the internal space K0 under a clean environment.

The substrate S carried out from the internal space K0 passes through the chamber apparatus 70, the arm portion 71, and the substrate guide stage 66, and thus is carried out from the baking portion BK. Then, the substrate S passes through the vacuum drying portion VD and the coating application portion CT and returns to the substrate supplying/collecting portion LU. After the substrate S returns to the substrate supplying/collecting portion LU, the control portion CONT causes the lid portion 14 to be opened in a state where the gate valve V1 is closed. Subsequently, an operator collects the substrate S in the chamber 10 and set new substrate S in the accommodation chamber 10a of the chamber 10.

In a case where, after the substrate S returns to the substrate supplying/collecting portion LU, another coating film is additionally formed on the coating film F formed on the substrate S, the control portion CONT causes the substrate S to be re-transported to the coating application portion CT, and then causes the coating treatment, the vacuum drying treatment, and the baking treatment to be repeatedly performed on the substrate S. Accordingly, the coating films F are laminated on the substrate S.

According to the embodiment described above, the temperatures of parts (the inner surface 92a and the ceiling surface 93a) of the chamber main body 81, which are in contact with the internal space K0, are adjusted by the temperature adjustment portion 83, as described above. Thus, it is possible to prevent the vaporized substance from adhering to the inner surface 92a or the ceiling surface 93a. As a result, the substrate S can be accommodated under a clean environment.

Technical range of the invention is not limited to the embodiment described above and the embodiment can be appropriately modified as long as it does not depart from the scope of the invention.

In the embodiment described above, a sheath heater is used as the temperature adjustment portion 83, for example. However, without being limited thereto, a heating mechanism other than a sheath heater may be provided.

In the embodiment described above, sheath heaters constituting the temperature adjustment portion 83 are provided in only the lateral wall portion 92 and the ceiling portion 93, for example. However, the configuration is not limited thereto.

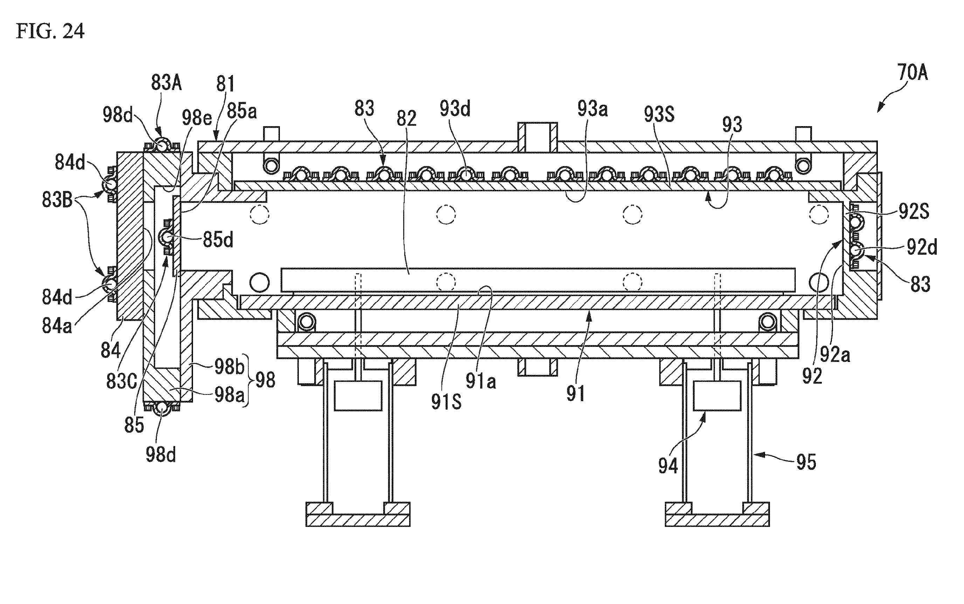

Fig. 24 is a view illustrating the configuration of a chamber apparatus 70A according to a modification example.

Temperature adjustment portions 83A, 83B, and 83C may be provided in the opening mechanism 98, as illustrated in Fig. 24.

The temperature adjustment portion 83A is provided in the first member 98a of the opening mechanism 98. A sheath heater 98d, for example, is used as the temperature adjustment portion 83A. The sheath heaters 98d are disposed on the +Z side surface and the -Z side surface of the first member 98a. Accordingly, the temperature of an inner surface 98e which is in contact with the internal space K0 can be adjusted in such a manner that the first member 98a is heated. Thus, it is possible to prevent the vaporized substance from being solidified and adhering to the inner surface 98e. Needless to say, the sheath heater 98d may be disposed on other positions, such as the inner surface 98e of the first member 98a.

The temperature adjustment portion 83B is provided in the first opening/closing member 84 of the opening mechanism 98. The sheath heater 84d, for example, is used as the temperature adjustment portion 83B. The sheath heater 84d is fixed to the -X side surface of the first opening/closing member 84. Accordingly, the temperature of an inner surface 84a which is in contact with the internal space K0 can be adjusted in such a manner that the first opening/closing member 84 is heated. Thus, it is possible to prevent the vaporized substance from being solidified and adhering to the inner surface 84a. Needless to say, the sheath heater 84d may be disposed on other positions, such as the +Z side surface, the -Z side surface, the +Y side surface, and the -Y side surface of the first opening/closing member 84.

The temperature adjustment portion 83C is provided in the second opening/closing member 85 of the opening mechanism 98. The sheath heater 85d, for example, is used as the temperature adjustment portion 83C. The sheath heater 85d is fixed to the -X side surface of the second opening/closing member 85. Accordingly, the temperature of an inner surface 85a which is in contact with the internal space K0 can be adjusted in such a manner that the second opening/closing member 85 is heated. Thus, it is possible to prevent the vaporized substance from being solidified and adhering to the inner surface 85a. Needless to say, the sheath heater 85d may be disposed on other positions, such as the +Z side surface, the -Z side surface, the +Y side surface, and the -Y side surface of the second opening/closing member 85.

In the description of the embodiment, a sheath heater is used as the temperature adjustment portion 83. However, without being limited thereto, the inner surface 92a and the ceiling surface 93a may be heated by a temperature adjusting medium.

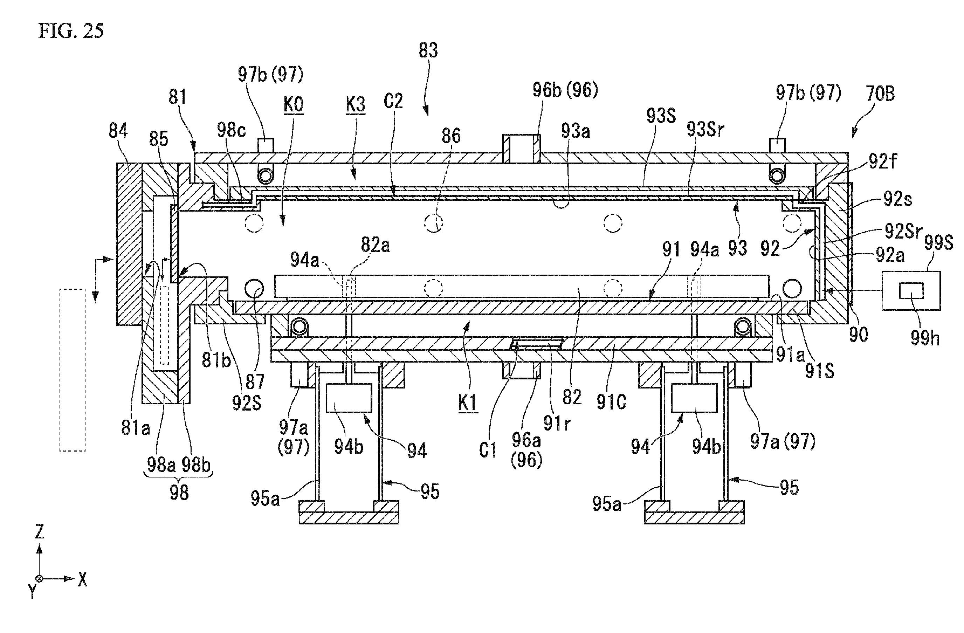

Fig. 25 is a view illustrating a configuration of a chamber apparatus 70B according to a modification example.

Flow paths 92Sr and 93Sr are formed in the wall member 92S and the ceiling plate 93S of the chamber apparatus 70B, as illustrated in Fig. 25. A temperature adjusting medium C2 can flow through the flow paths 92Sr and 93Sr. The flow paths 92Sr and 93Sr communicate with each other. Thus, the temperature adjusting medium C2 flows between the flow paths 92Sr and 93Sr.

Known oils for temperature adjustment, for example, can be used as the temperature adjusting medium C2. A temperature adjusting medium supply portion 99s (not illustrated) is provided in the chamber apparatus 70B to supply the temperature adjusting medium C2 to the flow paths 92Sr and 93Sr. The temperature adjusting medium supply portion has a heating portion 99h which heats the temperature adjusting medium C2 to be supplied to the flow paths 92Sr and 93Sr, in advance. Accordingly, the temperature adjusting medium C2 in a heated state is supplied to the flow paths 92Sr and 93Sr. When the temperature adjusting medium C2 flows through the flow paths 92Sr and 93Sr, heat of the temperature adjusting medium C2 is transferred to the lateral wall portion 92 and the ceiling portion 93. The heating temperature of the temperature adjusting medium C2 can be set to substantially the temperature at which the temperatures of the lateral wall portion 92 and the ceiling portion 93 reach a predetermined temperature. This temperature can be adjusted based on the result of an experiment, simulation, actual use or the like. Furthermore, a sheath heater is not provided in the chamber apparatus 70B.

According to this configuration, the temperatures of the lateral wall portion 92 and the ceiling portion 93 can be adjusted in such a manner that the temperature adjusting medium C2 flows. Thus, upon comparison with a case where the temperature adjustment is performed using a heating wire, it is possible to reduce the power consumption. Furthermore, in the above description, the temperature adjusting medium C2 in a heated state flows through the flow paths 92Sr and 93Sr. However, the configuration is not limited thereto. For example, the temperature adjusting medium C2 in a cooled state may be supplied to the flow paths 92Sr and 93Sr. In this case, it is possible to cool the lateral wall portion 92 and the ceiling portion 93 in a heated state.

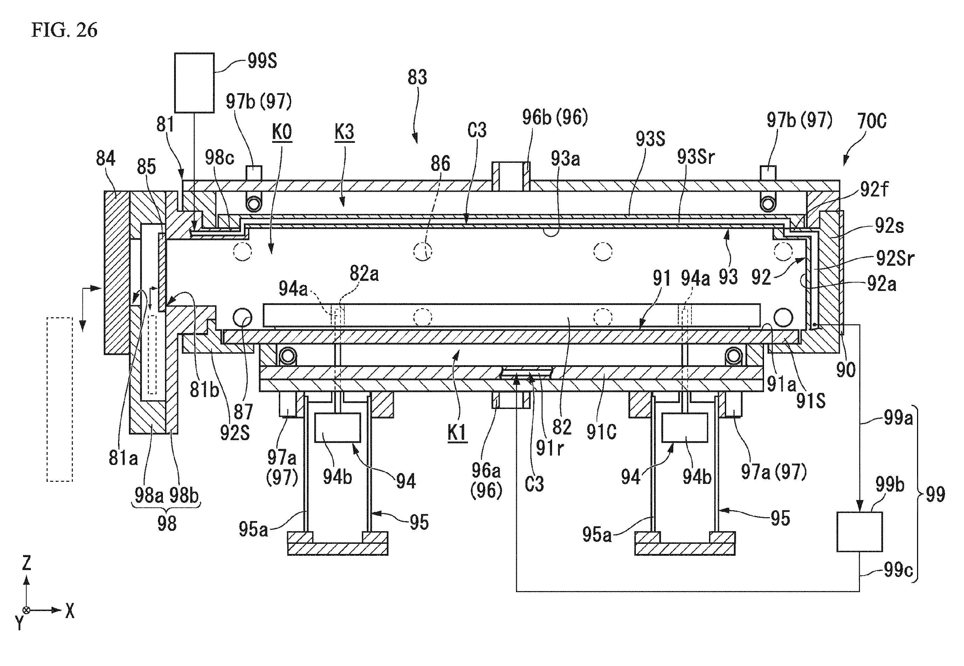

Fig. 26 is a view illustrating a configuration of a chamber apparatus 70C according to another modification example.

Similarly to the chamber apparatus 70B, the flow paths 92Sr and 93Sr are formed in the wall member 92S and the ceiling plate 93S of the chamber apparatus 70C, as illustrated in Fig. 26. In the chamber apparatus 70C, the flow paths 92Sr and 93Sr are connected to the flow path 91 r formed in the temperature adjustment plate 91 C, by a temperature adjusting medium driving portion 99.

The temperature adjusting medium driving portion 99 has a first flow path 99a, a main body portion 99b, and a second flow path 99c. The first flow path 99a connects the flow path 93Sr (or may be the flow path 92Sr) and the main body portion 99b. The second flow path 99c connects the main body portion 99b and the flow path 91 r.

The main body portion 99b sucks, from the first flow path 99a, a temperature adjusting medium C3 which flows through the flow path 93Sr (or may be the flow path 92Sr) and cools the temperature adjusting medium C3 to a predetermined temperature. The temperature adjusting medium C3 is supplied from the temperature adjusting medium supply portion 99S or the like which is provided separately. After the main body portion 99b cools the temperature adjusting medium C3 to the predetermined temperature, the main body portion 99b supplies the temperature adjusting medium C3 to the flow path 91 r through the second flow path 99c. The temperature adjusting medium C3 supplied to the flow path 91r flows through the flow path 91r, and then is discharged, by a discharge portion (not illustrated), to the external portion of the flow path 91r.

According to the configuration described above, the temperature adjusting medium C3 can flow through the flow paths 92Sr and 93Sr and the flow path 91r, and thus it is possible to easily manage the temperature adjusting medium C3. Furthermore, a common driving system can be used for the temperature adjusting medium C3, and thus it is possible to easily control the flow of the temperature adjusting medium C3.

The temperature adjusting medium C3 which is discharged, through the discharge portion, to the external side of the flow path 91r may return to the temperature adjusting medium supply portion 99S through a flow path (not illustrated). Accordingly, the temperature adjusting medium C3 can circulate through the flow paths 92Sr and 93Sr and the flow path 91 r, and thus it is possible to effectively adjust the temperature.

In the above description, the temperature adjusting medium C3 in a heated state is supplied to the flow paths 92Sr and 93Sr and the temperature adjusting medium C3 in a cooled state is supplied to the flow path 91 r. However, the configuration is not limited thereto. For example, the temperature adjusting medium C3 in a cooled state may be supplied to the flow paths 92Sr and 93Sr and the temperature adjusting medium C3 in a heated state may be supplied to the flow path 91 r.

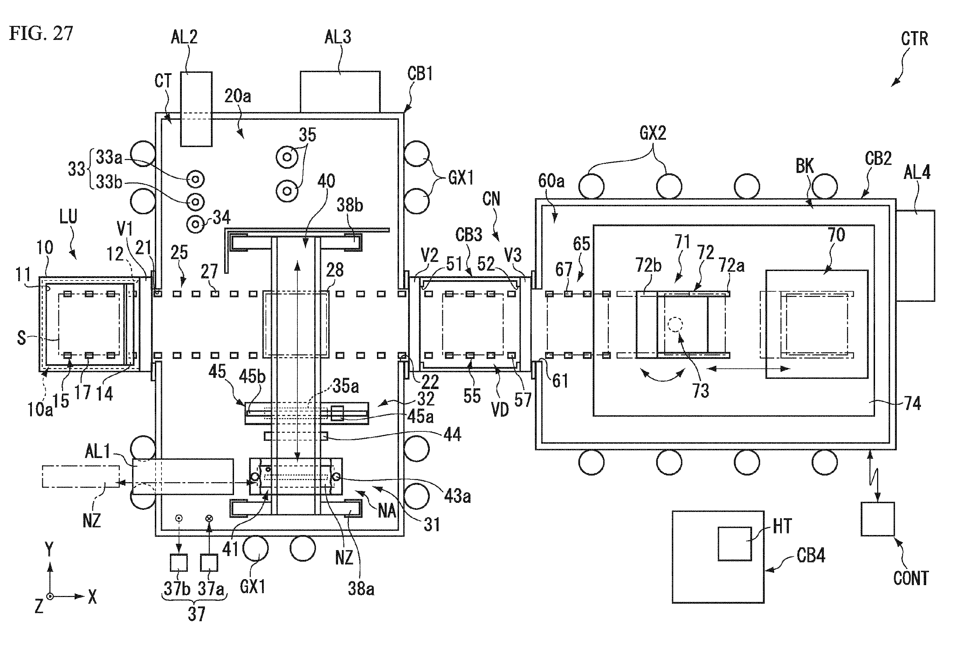

In the embodiment described above, the baking operation is performed in the baking portion BK of the second chamber CB2. However, the configuration is not limited thereto. A fourth chamber CB4, for example, may be additionally provided in a position different from that of the second chamber CB2 and the substrate S may be heated by a heating portion HT provided in the fourth chamber CB4, as illustrated in Fig. 27.

In this case, after the coating film F is laminated on the substrate S, for example, a heating treatment (a second heating step) for baking the laminated coating film F can be performed in the heating portion HT of the fourth chamber CB4. During the heating treatment in the second heating step, the coating film F is heated at a heating temperature higher than the temperature in the heating treatment by the baking portion BK. A solid content (a metal component) in the laminated coating film F can be crystallized by the heating treatment, and thus it is possible to further improve the quality of the coating film F.

The heating operation subsequent to laminating of the coating film F on the substrate S may be performed in the baking portion BK of the second chamber CB2. In this case, in the baking portion BK, the temperature may be controlled such that the heating temperature at the time of baking the coating films F in a laminated state is higher than the heating temperature at the time of baking each coating film F.

In the embodiment described above, in the vacuum drying portion VD, the heating portion 53 is disposed on the -Z side (a lower side in a vertical direction) of the substrate S. However, without being limited thereto, the heating portion 53 may be disposed on, for example, the +Z side (an upper side in the vertical direction) of the substrate S. Furthermore, the heating portion 53 may be movable between the -Z side position and the +Z side position of the substrate S, using the lifting mechanism 53a. In this case, the heating portion 53 may be formed in a shape (for example, an opening portion being provided in the heating portion 53) in which the plurality of rollers 57 constituting the substrate transport portion 55 can pass through the heating portion 53.

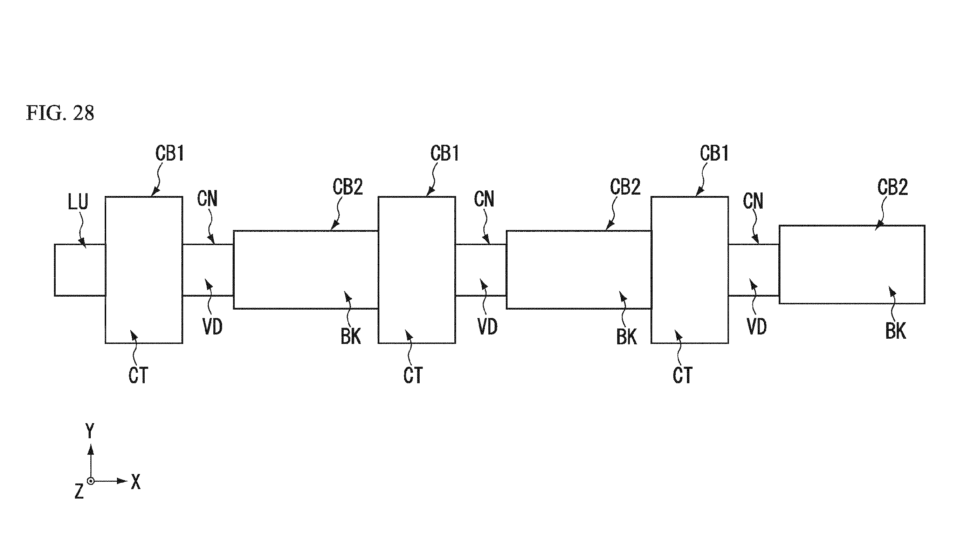

The coating applicator CTR may have a configuration in which the first chamber CB1 having the coating application portion CT, the connection portion CN having the vacuum drying portion VD, and the second chamber CB2 having the baking portion BK are repeatedly arranged on the +X side of the substrate supplying/collecting portion LU, as illustrated in Fig. 28.

A configuration in which the first chamber CB1, the connection portion CN, and the second chamber CB2 are repeatedly arranged three times is illustrated in Fig. 28. However the configuration is not limited thereto. The first chamber CB1, the connection portion CN, and the second chamber CB2 may be repeatedly arranged two times or the first chamber CB1, the connection portion CN, and the second chamber CB2 may be repeatedly arranged four or more times.

According to the configuration described above, the first chamber CB1, the connection portion CN, and the second chamber CB2 are repeatedly arranged in the X direction in serial. Accordingly, it is only necessary to transport the substrate S in one direction (the +X direction) and it is not necessary to reciprocate the substrate S in the X direction, and thus it is possible to continuously perform laminating processes of the coating film on the substrate S. As a result, it is possible to effectively form the coating film on the substrate S.

The shapes of the respective components and the combinations thereof described in the above example are only examples and can be modified in various ways, based on the design requirements or the likes. In the embodiment described above, the coating application portion CT has a configuration using a slit type nozzle portion NZ, for example. However, without being limited thereto, a central dripping type coating application portion, for example, may be used or ink jet type coating application portion may be used. Furthermore, application may be performed by spreading the liquid body on the substrate S, using a squeegee, for example.

In a case where, for example, a treatment using the coating applicator CTR is performed, in at least one of chamber facilities, each of which includes the first chamber CB1, the second chamber CB2, the third chamber CB3, and the chamber apparatus 70, if it is necessary, a maintenance process or a process (for example, moving the structure, cleaning, atmosphere adjustment, temperature adjustment) for setting an ambient state or the inner state of the chamber apparatus to a predetermined state (for example, an initial state, a predetermined atmosphere state, and a predetermined temperature state) may be appropriately performed at a predetermined timing (including a time before or after the treatment is performed in each chamber, for example, before or after the substrate S is carried in/out to/from the chamber apparatus, before or after the liquid body Q is discharged through the nozzle portion NZ, before or after the heating portion 53 performs the heating operation, before or after the heating plate 82 performs the heating operation) in an operation period or in a non-operation period.

When, for example, the maintenance process described above or each process for setting the state to the predetermined state is performed, cleaning may be performed using, for example, a cleaning solution. Alternatively, at least one gas of various kinds of gases, such as nitrogen gas, oxygen gas, argon gas, air, water vapor, or other kinds of gas may be appropriately supplied to a periphery or the inner portion of each chamber apparatus, using the gas supply portion 58, the gas supply portion 87, or a configuration corresponding thereto. In addition, if it is necessary, a transporting system (for example, a roller, and an arm) may be appropriately operated.

In the embodiment described above, when the coating applicator CTR is accommodated in one room, a gas supply/discharge portion for adjusting the atmosphere of the room may be provided. In this case, for example, a vaporized solvent in the atmosphere of the room can be exhausted using the gas supply/discharge portion, and thus cleaning of the atmosphere can be performed on the entirety of the room. Therefore, it is possible to more reliably prevent a coating application condition from changing.

The components which are described as the embodiment or the modification examples thereof can be appropriately combined, as long as it does not depart from the scope of the invention. Some of a plurality of the components which are used in combination may be appropriately removed.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A chamber apparatus comprising:
a chamber, in a part of which an internal space capable of accommodating a substrate therein is formed;
a heating portion which heats the substrate disposed in the internal space; and
a temperature adjustment portion which adjusts the temperature of a part of the chamber, which is in contact with the internal space.

2. The chamber apparatus according to claim 1,
wherein the chamber has a second temperature adjustment portion which can adjust the temperature of the substrate disposed in the internal space.

3. The chamber apparatus according to claim 2,
wherein the chamber has a substrate holding portion which holds the substrate disposed in the internal space, and
wherein the second temperature adjustment portion is provided in the substrate holding portion.

4. The chamber apparatus according to claim 3,
wherein the second temperature adjustment portion has a flow path through which a temperature adjusting medium capable of heating or cooling the substrate holding portion flows.

5. The chamber apparatus according to claim 3,
wherein the heating portion is provided in the substrate holding portion.

6. The chamber apparatus according to claim 1,
wherein the chamber has a wall portion which surrounds the substrate disposed in the internal space, and
wherein the temperature adjustment portion is provided in the wall portion.

7. The chamber apparatus according to claim 6,
wherein the temperature adjustment portion is provided in an inner portion of the wall portion.

8. The chamber apparatus according to claim 1,
wherein the chamber has:
an opening portion which allows the internal space to communicate with the outside; and
a first gate portion which can block the opening portion, and
wherein the temperature adjustment portion is provided in the first gate portion.

9. The chamber apparatus according to claim 8,
wherein the chamber has a second gate portion which can block the opening portion, and
wherein the temperature adjustment portion is provided in the second gate portion.

10. The chamber apparatus according to claim 1,
wherein the chamber has:
a transfer portion which can move in a predetermined direction in the internal space and which performs transferring of the substrate between the transfer portion and the substrate holding portion; and
a second wall portion which surrounds a movement path of the transfer portion, and
wherein the temperature adjustment portion is provided in the second wall portion.

11. A heating method comprising:
an accommodating step of accommodating a substrate in a chamber, in a part of which an internal space capable of accommodating the substrate therein is formed;
a heating step for heating the substrate disposed in the internal space; and
a temperature adjusting step for adjusting the temperature of a part of the chamber, which is in contact with the internal space.

12. The heating method according to claim 11,
wherein the temperature adjusting step includes a second temperature adjusting step for adjusting the temperature of the substrate disposed in the internal space.

13. The heating method according to claim 12,
wherein the accommodating step includes holding the substrate in a substrate holding portion disposed in the internal space, and
wherein the second temperature adjusting step includes cooling the substrate holding portion.

14. The heating method according to claim 13,
wherein the second temperature adjusting step includes flowing a temperature adjusting medium capable of cooling the substrate holding portion through a flow path provided in the substrate holding portion.

15. The heating method according to claim 13,
wherein the heating step includes heating the substrate holding portion.

16. The heating method according to claim 11,
wherein the chamber has a wall portion which surrounds the substrate disposed in the internal space, and
wherein the temperature adjusting step includes adjusting the temperature of the wall portion.

17. The heating method according to claim 16,
wherein the temperature adjusting step includes adjusting the temperature of the wall portion from an inner side thereof.

18. The heating method according to claim 11,
wherein the chamber has:
an opening portion which allows the internal space to communicate with the outside; and
a first gate portion which can block the opening portion, and
wherein the temperature adjusting step includes adjusting the temperature of the first gate portion.

19. The heating method according to claim 18,
wherein the chamber has a second gate portion which can block the opening portion, and
wherein the temperature adjusting step includes adjusting the temperature of the second gate portion.

20. The heating method according to claim 11,
wherein the chamber has:
a transfer portion which can move in a predetermined direction in the internal space and which performs transferring of the substrate between the transfer portion and the substrate holding portion; and
a second wall portion which surrounds a movement path of the transfer portion, and
wherein the temperature adjusting step includes adjusting the temperature of the second wall portion.
